# EUROPEAN PATENT SPECIFICATION

(11) **EP 4 429 429 B1**
(45) Date of publication and mention of the grant of the patent: **29.04.2026**
(21) Application number: 23814350.7
(22) Date of filing: 06.11.2023
(51) Int. Cl.: H05K 7/20, F28D 15/02, G06F 1/20, G06F 1/16

(54) **ELECTRONIC DEVICE COMPRISING STRUCTURE FOR DISPERSING HEAT**
ELEKTRONISCHE VORRICHTUNG MIT STRUKTUR ZUR WÄRMEABLEITUNG
DISPOSITIF ÉLECTRONIQUE COMPRENANT UNE STRUCTURE DE DISSIPATION DE CHALEUR

(30) Priority: 20.01.2023 KR 20230009085; 31.01.2023 KR 20230013279
(43) Date of publication of application: 11.09.2024
(73) Proprietor: Samsung Electronics Co., Ltd., Suwon-si, Gyeonggi-do 16677 (KR)
(72) Inventor: KANG, Seunghoon, Suwon-si Gyeonggi-do 16677 (KR); KWON, Ohhyuck, Suwon-si Gyeonggi-do 16677 (KR); PARK, Yoonsun, Suwon-si Gyeonggi-do 16677 (KR); PARK, Jongkil, Suwon-si Gyeonggi-do 16677 (KR); SUNG, Jungoh, Suwon-si Gyeonggi-do 16677 (KR); SON, Changjong, Suwon-si Gyeonggi-do 16677 (KR); YUN, Hajoong, Suwon-si Gyeonggi-do 16677 (KR)
(74) Representative: HGF
(86) International application number: PCT/KR2023/017696
(87) International publication number: WO 2024/154906

(56) References cited:
- WO-A1-2022/039305
- KR-A- 20210 103 888
- KR-A- 20220 119 856
- US-A1- 2015 083 371
- US-A1- 2016 081 227
- US-A1- 2019 390 919
- US-A1- 2021 400 846
- US-A1- 2022 272 868
- US-A1- 2023 019 481

## Description

### [Technical Field]

Embodiments to be described later relate to an electronic device including a structure for dispersing heat.

### [Background Art]

An electronic device may include various electronic components in order to meet user needs. The electronic device may be miniaturized so that it may be worn by the user or carried by the user. As the electronic components disposed in the electronic device perform an operation for responding to a user's request, heat may be generated in the miniaturized electronic device.
US 2023019481A1 relates to a vapor chamber for a mobile terminal.
US 2019390919 A1 relates to a polymer-based thermal ground plane.

### [Disclosure]

### [Technical Solution]

The present invention is defined by the independent claims. Further aspects of the present invention are outlined in the dependent claims. According to an embodiment, an electronic device may comprise a printed circuit board, a processor on the printed circuit board, and a vapor chamber spaced apart from the printed circuit board and at least partially disposed over the processor. The electronic device may comprise a metal plate, disposed on the printed circuit board, including a seating groove in which at least a portion of the vapor chamber 400 is accommodated and including a first portion on the processor for transferring heat emitted from the processor to the vapor chamber and a second portion extending from the first portion and having a slit formed therein. The vapor chamber may include a first plate including a base supported by the first portion of the seating groove and having at least a portion disposed on the slit, and a sidewall extending from a periphery of the base toward an outside of the seating groove. The vapor chamber may include a second plate contacting the sidewall and including a first region disposed on the first portion, a second region disposed on the slit of the second portion, a third region extending from the first region to the second region and located on the boundary between the first portion and the second portion, and a plurality of pillars protruding toward the base and including an end having flat shape at a position adjacent to the base. The plurality of pillars may include a first set of pillars having a first pattern in the first
region and the second region, and a second set of pillars having a second pattern different from the first pattern in the third region.

According to an embodiment, an electronic device may comprise a printed circuit board, a processor on the printed circuit board, and a vapor chamber spaced apart from the printed circuit board and at least partially disposed over the processor. The electronic device may comprise a metal plate, disposed on the printed circuit board, including a seating groove in which at least a portion of the vapor chamber is accommodated and including a first portion on the processor for transferring heat emitted from the processor to the vapor chamber and a second portion extending from the first portion and having a slit formed therein. The vapor chamber may include a first plate including a base supported by the first portion of the seating groove and having at least a portion disposed on the slit, and a sidewall extending from a periphery of the base toward an outside of the seating groove. The vapor chamber may include a second plate contacting the sidewall and including a first region disposed on the first portion, a second region disposed on the slit of the second portion, a third region extending from the first region to the second region and located on the boundary between the first portion and the second portion, and a plurality of pillars protruding toward the base and including an end having flat shape at a position adjacent to the base. The vapor chamber may further include at least one of stainless steel and titanium. The plurality of pillars may include a first set of pillars having a first pattern in the first region and the second region, and a second set of pillars having a second pattern different from the first pattern in the third region. A rigidity of the third region may be greater than a rigidity of the first region and a rigidity of the second region.

### [Description of the Drawings]

FIG. 1 is a block diagram of an electronic device in a network environment according to an embodiment.
FIG. 2 is a diagram illustrating an electronic device according to an embodiment.
FIG. 3 is an exploded perspective view of an electronic device according to an embodiment.
FIG. 4A illustrates an exemplary electronic device.
FIG. 4B is a cross-sectional view of an exemplary vapor chamber cut along line A-A' of FIG. 4A.
FIGS. 5A, 5B, and 5C illustrate a portion of an exemplary vapor chamber.
FIGS. 6A and 6B illustrate a portion of an exemplary vapor chamber.
FIG. 7A illustrates the inside of an exemplary electronic device in which a vapor chamber is disposed.
FIG. 7B is a cross-sectional view of an exemplary electronic device cut along line B-B' of FIG. 7A.
FIG. 7C is a cross-sectional view of an exemplary electronic device cut along line C-C' of FIG. 7A.

### [Mode for Invention]

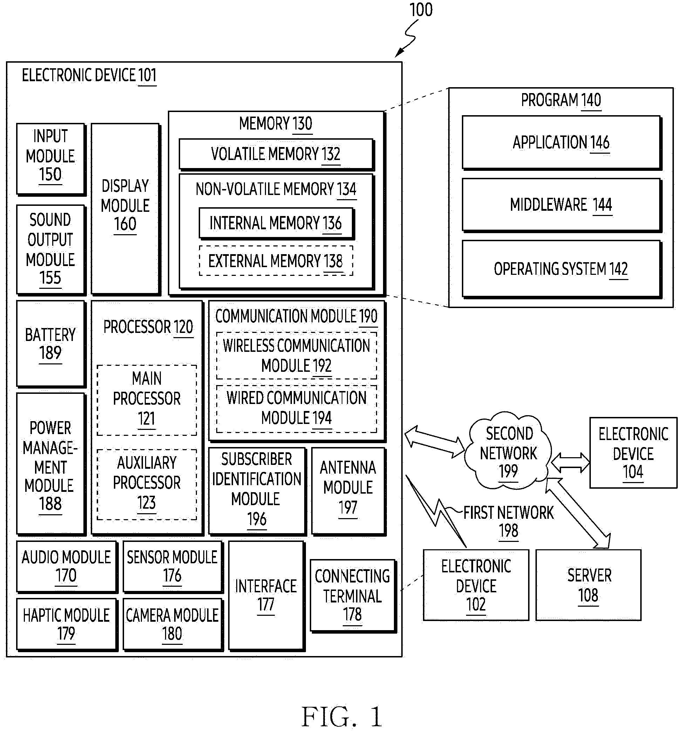

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

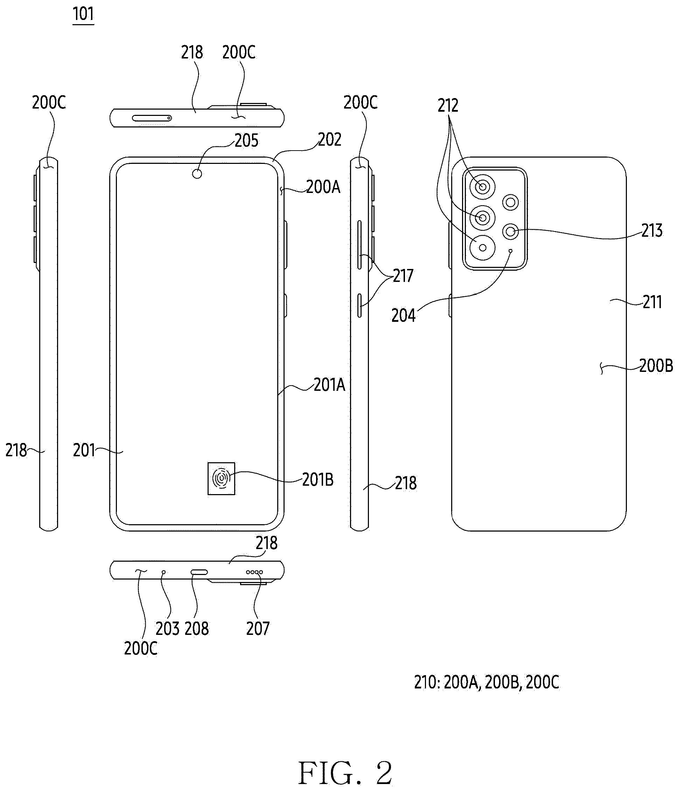

FIG. 2 is a diagram illustrating an electronic device according to an embodiment.

Referring to FIG. 2, an electronic device 101 according to an embodiment may include a housing 210 forming an exterior of the electronic device 101. For example, the housing 210 may include a front surface 200A, a rear surface 200B, and a side surface 200C surrounding a space between the front surface 200A and the rear surface 200B. According to an embodiment, the housing 210 may refer to a structure forming at least a portion of the front surface 200A, the rear surface 200B, and/or the side surface 200C.

The electronic device 101 according to an embodiment may include a substantially transparent front plate 202. According to an embodiment, the front plate 202 may form at least a portion of the front surface 200A. According to an embodiment, the front plate 202 may include, for example, a glass plate including various coating layers or a polymer plate, but the disclosure is not limited thereto.

The electronic device 101 according to an embodiment may include a substantially opaque rear plate 211. According to an embodiment, the rear plate 211 may form at least a portion of the rear surface 200B. According to an embodiment, the rear plate 211 may be formed of coated or colored glass, ceramic, polymer, metal (e.g., aluminum, stainless steel (STS), or magnesium), or a combination of at least two of the above materials.

The electronic device 101 according to an embodiment may include a side structure (or side member) 218. According to an embodiment, the side structure 218 may be coupled to the front plate 202 and/or the rear plate 211 to form at least a portion of the side surface 200C of the electronic device 101. For example, the side structure 218 may form all of the side surface 200C of the electronic device 101, and for another example, the side structure 218 may form the side surface 200C of the electronic device 101 together with the front plate 202 and/or the rear plate 211.

Unlike the illustrated embodiment, in the case that the side surface 200C of the electronic device 101 is partially formed by the front plate 202 and/or the rear plate 211, the front plate 202 and/or the rear plate 211 may include a region that is bent from its periphery toward the rear plate 211 and/or the front plate 202 and seamlessly extends. The extended region of the front plate 202 and/or the rear plate 211 may be positioned at both ends of, for example, a long edge of the electronic device 101, but the disclosure is not limited to the above-described examples.

According to an embodiment, the side structure 218 may include a metal and/or a polymer. According to an embodiment, the rear plate 211 and the side structure 218 may be integrally formed and may include the same material (e.g., a metal material such as aluminum), but the disclosure are not limited thereto. For example, the rear plate 211 and the side structure 218 may be formed in separate configurations and/or may include different materials.

According to an embodiment, the electronic device 101 may include at least one of a display 201, an audio module 203, 204 and 207, a sensor module (not shown), a camera module 205, 212, 213, a key input device 217, a light emitting device (not shown), and/or a connector hole 208. According to another embodiment, the electronic device 101 may omit at least one of the components (e.g., a key input device 217 or a light emitting device (not shown)), or may further include another component.

According to an embodiment, the display 201 may be visually exposed through a substantial portion of the front plate 202. For example, at least a portion of the display 201 may be visible through the front plate 202 forming the front surface 200A. According to an embodiment, the display 201 may be disposed on the second surface of the front plate 202.

According to an embodiment, the appearance of the display 201 may be formed substantially the same as the appearance of the front plate 202 adjacent to the display 201. According to an embodiment, in order to expand the area in which the display 201 is visually exposed, the distance between the outside of the display 201 and the outside of the front plate 202 may be formed to be generally the same.

According to an embodiment, the display 201 (or the front surface 200A of the electronic device 101) may include a screen display area 201A. According to an embodiment, the display 201 may provide visual information to a user through the screen display area 201A. In the illustrated embodiment, when the front surface 200A is viewed from the front, it is illustrated that the screen display area 201A is spaced apart from the outside of the front surface 200A and is positioned inside the front surface 200A, but the disclosure is not limited thereto. In another embodiment, when the front surface 200A is viewed from the front, at least a portion of the periphery of the screen display area 201A may substantially coincide with the periphery of the front surface 200A (or the front plate 202).

According to an embodiment, the screen display area 201A may include a sensing area 201B configured to obtain biometric information of a user. Here, the meaning of "the screen display area 201A including the sensing area 201B" may be understood to mean that at least a portion of the sensing area 201B may be overlapped on the screen display area 201A. For example, the sensing area 201B, like other areas of the screen display area 201A, may refer to an area in which visual information may be displayed by the display 201 and additionally biometric information (e.g., fingerprint) of a user may be obtained. In another embodiment, the sensing area 201B may be formed in the key input device 217.

According to an embodiment, the display 201 may include an area in which the first camera module 205 is positioned. According to an embodiment, an opening may be formed in the area of the display 201, and the first camera module 205 (e.g., a punch hole camera) may be at least partially disposed in the opening to face the front surface 200A. In such a case, the screen display area 201A may surround at least a portion of the periphery of the opening. According to an embodiment, the first camera module 205 (e.g., an under display camera (UDC)) may be disposed under the display 201 to overlap the area of the display 201. In this case, the display 201 may provide visual information to the user through the area, and additionally, the first camera module 205 may obtain an image corresponding to a direction facing the front surface 200A through the area of the display 201.

According to an embodiment, the display 201 may be coupled to or disposed adjacent to a touch sensing circuit, a pressure sensor capable of measuring the intensity (pressure) of the touch, and/or a digitizer that detects a magnetic field type stylus pen.

According to an embodiment, the audio modules 203, 204 and 207 may include microphone holes 203 and 204, and a speaker hole 207.

According to an embodiment, the microphone holes 203 and 204 may include a first microphone hole 203 formed in a partial area of the side surface 200C and a second microphone hole 204 formed in a partial area of the rear surface 200B. A microphone (not shown) for obtaining an external sound may be disposed inside the microphone holes 203 and 204. The microphone may include a plurality of microphones to detect the direction of sound.

According to an embodiment, the second microphone hole 204 formed in a partial area of the rear surface 200B may be disposed adjacent to the camera modules 205, 212 and 213. For example, the second microphone hole 204 may obtain sound according to operations of the camera modules 205, 212, and 213. However, the disclosure is not limited thereto.

According to an embodiment, the speaker hole 207 may include an external speaker hole 207 and a receiver hole (not illustrated) for a call. The external speaker hole 207 may be formed on a portion of the side surface 200C of the electronic device 101. According to an embodiment, the external speaker hole 207 may be implemented as a single hole together with the microphone hole 203. Although not illustrated, a receiver hole (not shown) for a call may be formed on another portion of the side surface 200C. For example, the receiver hole for a call may be formed on the opposite side of the external speaker hole 207 on the side surface 200C. For example, with respect to the illustration of FIG. 2, the external speaker hole 207 may be formed on the side surface 200C corresponding to the lower end of the electronic device 101, and the receiver hole for a call may be formed on the side surface 200C corresponding to the upper end of the electronic device 101. However, the disclosure is not limited thereto, and according to an embodiment, the receiver hole for a call may be formed at a position other than the side surface 200C. For example, the receiver hole for a call may be formed by a space spaced apart between the front plate 202 (or display 201) and the side bezel structure 218.

According to an embodiment, the electronic device 101 may include at least one speaker (not illustrated) configured to output sound to the outside of the housing 210 through an external speaker hole 207 and/or a receiver hole (not shown) for a call.

According to an embodiment, the sensor module (not shown) may generate an electrical signal or data value corresponding to an internal operating state or an external environmental state of the electronic device 101. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, and an illumination sensor.

According to an embodiment, the camera modules 205, 212 and 213 may include a first camera module 205 disposed to face the front surface 200A of the electronic device 101, a second camera module 212 disposed to face the rear surface 200B, and a flash 213.

According to an embodiment, the second camera module 212 may include a plurality of cameras (e.g., a dual camera, a triple camera, or a quad camera). However, the second camera module 212 is not necessarily limited to including a plurality of cameras, and may include one camera.

According to an embodiment, the first camera module 205 and the second camera module 212 may include one or a plurality of lenses, an image sensor, and/or an image signal processor.

According to an embodiment, the flash 213 may include, for example, a light emitting diode or a xenon lamp. According to an embodiment, two or more lenses (infrared camera, wide-angle and telephoto lens) and image sensors may be disposed on one side of the electronic device 101.

According to an embodiment, the key input device 217 (e.g., an input module 150 of FIG. 1) may be disposed on the side surface 200C of the electronic device 101. According to an embodiment, the electronic device 101 may not include some or all of the key input devices 217, and the key input device 217 not included therein may be implemented on the display 201 in another form such as a soft key.

According to an embodiment, the connector hole 208 may be formed on the side surface 200C of the electronic device 101 to accommodate the connector of the external device. A connection terminal electrically connected to the connector of the external device may be disposed in the connector hole 208. The electronic device 101 according to an embodiment may include an interface module for processing electrical signals transmitted and received through the connection terminal.

According to an embodiment, the electronic device 101 may include a light emitting device (not shown). For example, the light emitting device (not shown) may be disposed on the front surface 200A of the housing 210. The light emitting device (not shown) may provide state information of the electronic device 101 in a form of light. In another embodiment, the light emitting device (not shown) may provide a light source when the first camera module 205 is operated. For example, the light emitting device (not shown) may include an LED, an IR LED, and/or a xenon lamp.

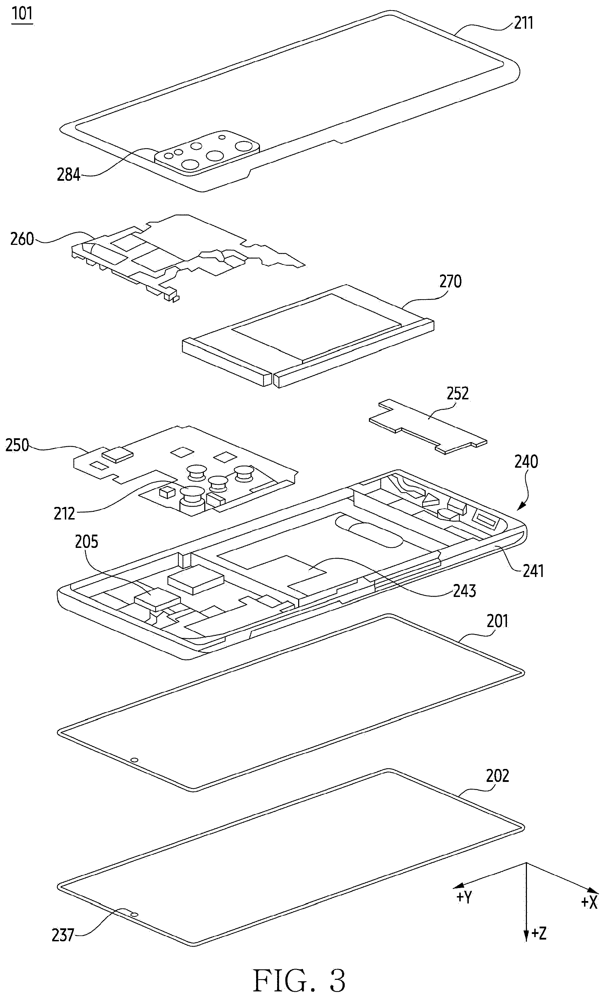

FIG. 3 is an exploded perspective view of an electronic device according to an embodiment.

Hereinafter, overlapping descriptions of components having the same reference numerals as those of the above-described components will be omitted.

Referring to FIG. 3, the electronic device 101 according to an embodiment may include a frame structure 240, a first printed circuit board 250, a second printed circuit board 252, a cover plate 260, and a battery 270.

According to an embodiment, the frame structure 240 may include a sidewall 241 forming an exterior (e.g., the third surface 200C of FIG. 2) of the electronic device 101 and a support portion 243 extending inward from the sidewall 241. According to an embodiment, the frame structure 240 may be disposed between the display 201 and the rear plate 211. According to an embodiment, the sidewall 241 of the frame structure 240 may surround a space between the rear plate 211 and the front plate 202 (and/or the display 201), and the support portion 243 of the frame structure 240 may extend from the sidewall 241 within the space.

According to an embodiment, the frame structure 240 may support or accommodate other components included in the electronic device 101. For example, the display 201 may be disposed on one surface of the frame structure 240 facing one direction (e.g., the +z direction), and the display 201 may be supported by the support portion 243 of the frame structure 240. For another example, a first printed circuit board 250, a second printed circuit board 252, a battery 270, and a rear camera 212 may be disposed on the other surface facing a direction opposite to the one direction (e.g., the -z direction) of the frame structure 240. The first printed circuit board 250, the second printed circuit board 252, the battery 270, and the rear camera 212 may be mounted on a recess defined by the sidewall 241 and/or the support portion 243 of the frame structure 240.

According to an embodiment, the first printed circuit board 250, the second printed circuit board 252, and the battery 270 may be coupled to the frame structure 240, respectively. For example, the first printed circuit board 250 and the second printed circuit board 252 may be fixedly disposed in the frame structure 240 through a coupling member such as a screw. For example, the battery 270 may be fixedly disposed on the frame structure 240 through an adhesive member (e.g., a double-sided tape). However, it is not limited by the above-described example.

According to an embodiment, a cover plate 260 may be disposed between the first printed circuit board 250 and the rear plate 211. According to an embodiment, the cover plate 260 may be disposed on the first printed circuit board 250. For example, the cover plate 260 may be disposed on a surface facing the -z direction of the first printed circuit board 250.

According to an embodiment, the cover plate 260 may at least partially overlap the first printed circuit board 250 with respect to the z-axis. According to an embodiment, the cover plate 260 may cover at least a partial area of the first printed circuit board 250. Through this, the cover plate 260 may protect the first printed circuit board 250 from physical impact or prevent the connector coupled to the first printed circuit board 250 from being separated.

According to an embodiment, the cover plate 260 may be fixedly disposed on the first printed circuit board 250 through a coupling member (e.g., a screw), or may be coupled to the frame structure 240 together with the first printed circuit board 250 through the coupling member.

According to an embodiment, the display 201 may be disposed between the frame structure 240 and the front plate 202. For example, a front plate 202 may be disposed on one side (e.g., a +z direction) of the display 201 and a frame structure 240 may be disposed on the other side (e.g., a -z direction).

According to an embodiment, the front plate 202 may be coupled to the display 201. For example, the front plate 202 and the display 201 may adhere to each other through an optical adhesive member (e.g., optically clear adhesive (OCA) or optically clear resin (OCR)) interposed therebetween.

According to an embodiment, the front plate 202 may be coupled to the frame structure 240. For example, the front plate 202 may include an outside portion extending outside the display 201 when viewed in the z-axis direction, and may adhere to the frame structure 240 through an adhesive member (e.g., a double-sided tape) disposed between the outside portion of the front plate 202 and the frame structure 240 (e.g., the sidewall 241). However, it is not limited by the above-described example.

According to an embodiment, the first printed circuit board 250 and/or the second printed circuit board 252 may be equipped with a processor (e.g., a processor 120 of FIG. 1), a memory (e.g., a memory 130 of FIG. 1), and/or an interface (e.g., an interface 177 of FIG. 1). The processor may include, for example, one or more of a central processing unit, an application processor, a graphic processing unit, an image signal processor, a sensor hub processor, or a communication processor. The memory may include, for example, a volatile memory or a nonvolatile memory. The interface may include, for example, a high definition multimedia interface (HDMI), a universal serial bus (USB) interface, an SD card interface, and/or an audio interface. The interface may electrically or physically connect the electronic device 101 to an external electronic device, and may include a USB connector, an SD card/MMC connector, or an audio connector. According to an embodiment, the first printed circuit board 250 and the second printed circuit board 252 may be operatively or electrically connected to each other through a connection member (e.g., a flexible printed circuit board).

According to an embodiment, the battery 270 may supply power to at least one component of the electronic device 101. For example, the battery 270 may include a rechargeable secondary cell or a fuel cell. At least a portion of the battery 270 may be disposed on substantially the same plane as the first printed circuit board 250 and/or the second printed circuit board 252.

The electronic device 101 according to an embodiment may include an antenna module (not illustrated) (e.g., an antenna module 197 of FIG. 1). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module, for example, may perform short-range communication with an external device, or wirelessly transmit and receive power to and from the external device.

According to an embodiment, the front camera 205 may be disposed in at least a portion (e.g., a support portion 243) of the frame structure 240 so that the lens may receive external light through a partial area (e.g., a camera area 237) of the front plate 202.

According to an embodiment, the rear camera 212 may be disposed between the frame structure 240 and the rear plate 211. According to an embodiment, the rear camera 212 may be electrically connected to the first printed circuit board 250 through a connection member (e.g., a connector). According to an embodiment, the rear camera 212 may be disposed such that the lens may receive external light through a camera area 284 of the rear plate 211 of the electronic device 101.

According to an embodiment, the camera area 284 may be formed on the surface (e.g., a rear surface 200B of FIG. 2) of the rear plate 211. According to an embodiment, the camera area 284 may be formed to be at least partially transparent so that external light may be incident to the lens of the rear camera 212. According to an embodiment, at least a portion of the camera area 284 may protrude from the surface of the rear plate 211 to a predetermined height. However, it is not limited to thereto, and in another embodiment, the camera area 284 may form a plane substantially the same as the surface of the rear plate 211.

According to an embodiment, the housing(e.g., a housing 210 of FIG. 2) of the electronic device 101 may mean a configuration or structure forming at least a portion of the exterior of the electronic device 101. In this regard, at least a portion of the front plate 202, the frame structure 240, and/or the rear plate 211 forming the exterior of the electronic device 101 may be referred to as the housing of the electronic device 101.

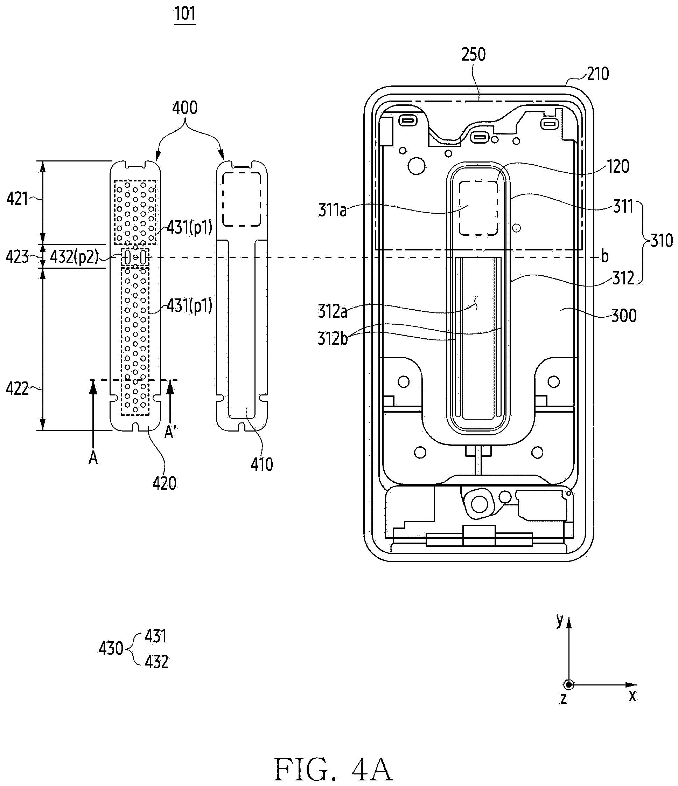

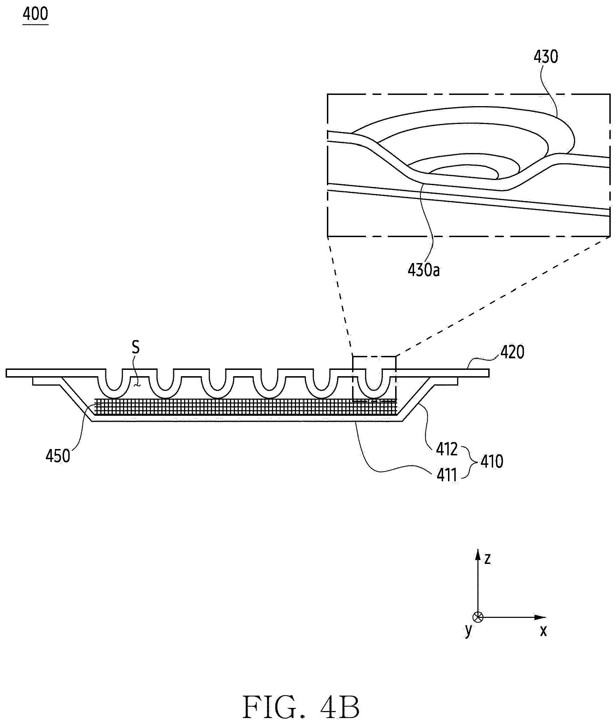

FIG. 4A illustrates an exemplary electronic device. FIG. 4B is a cross-sectional view of an exemplary vapor chamber cut along line A-A' of FIG. 4A.

Referring to FIGS. 4A and 4B, an electronic device 101 may include a first printed circuit board 250, a processor 120, a vapor chamber 400, and a metal plate 300.

According to an embodiment, the processor 120 may be disposed on the first printed circuit board 250. The processor 120 may be electrically connected to the first printed circuit board 250. The processor 120 may be disposed on one surface of the first printed circuit board 250 facing a display (e.g., a display 201 of FIG. 3). The processor 120 may perform data processing or calculation as the electronic device 101 operates. The processor 120 may emit heat according to performing of data processing or calculation.

According to an embodiment, the vapor chamber 400 may be spaced apart from the first printed circuit board 250 and at least partially disposed over the processor 120.

For example, at least a portion (e.g., a frame structure 240) of the housing 210 of the electronic device 101 may be disposed on one surface of the first printed circuit board 250 facing the +z direction. The processor 120 may be mounted on the one surface of the first printed circuit board 250. The vapor chamber 400 may be spaced apart from the first printed circuit board 250 by the at least a portion of the housing 210. The vapor chamber 400 may be disposed above the processor 120 based on the +z direction. For example, the at least a portion of the housing 210 may be disposed between the processor 120 and the vapor chamber 400. Since the vapor chamber 400 overlaps the processor 120 when viewed from above, at least some of the heat emitted from the processor 120 may be transferred to the vapor chamber 400. The vapor chamber 400 may disperse the heat transferred from the processor 120 in the +y direction and/or the -y direction.

The vapor chamber 400 has been described as dispersing heat of the processor 120, but is not limited thereto. By at least partially overlapping at least one electronic component that emits heat as the electronic device 101 operates, including the first printed circuit board 250, the vapor chamber 400 may be configured to disperse heat emitted from the at least one electronic component.

According to an embodiment, the metal plate 300 may support the vapor chamber 400. The metal plate 300 may be disposed on the first printed circuit board 250. For example, the metal plate 300 may be an internal structure (e.g., the frame structure 240 of FIG. 3) of the housing 210. For example, the metal plate 300 may include a portion disposed between the processor 120 disposed on one surface of the first printed circuit board 250 facing the metal plate 300 and the vapor chamber 400. Since the metal plate 300 contacts at least a portion of the vapor chamber 400, the heat emitted from the processor 120 and transferred to the vapor chamber 400 may diffuse to the metal plate 300 contacting the vapor chamber 400. The metal plate 300 may include at least one of aluminum and stainless steel, but is not limited thereto. By including the metal plate 300, the electronic device 101 may be configured to prevent the vapor chamber 400 from being directly exposed to the heat emitted from the processor 120 and to disperse the heat transferred from the processor 120 to the vapor chamber 400 through the metal plate 300.

According to an embodiment, the metal plate 300 may include a seating groove 310 in which at least a portion of the vapor chamber 400 is accommodated. The seating groove 310 may include a first portion 311 on the processor 120 for transferring the heat emitted from the processor 120 to the vapor chamber 400, and a second portion 312 extending from the first portion 311 and having a slit 312a formed thereon.

For example, the seating groove 310 may protrude from the metal plate 300 toward the -z direction in order to accommodate the vapor chamber 400. For example, the seating groove 310 may cover at least a portion of the vapor chamber 400. For example, the seating groove 310 may include supporting structures 311a and 312b configured so that the vapor chamber 400 may be supported on the metal plate 300.

For example, when viewing the metal plate 300 from above, the first portion 311 may at least partially overlap the processor 120. The first portion 311 may include a first supporting structure 311a configured to support the vapor chamber 400 and space the processor 120 and the vapor chamber 400 apart. The first supporting structure 311a may be disposed on a path through which the heat emitted from the processor 120 is transferred to the vapor chamber 400. For example, the first supporting structure 311a may be referred to as a supporting portion 243 of FIG. 3, but is not limited thereto.

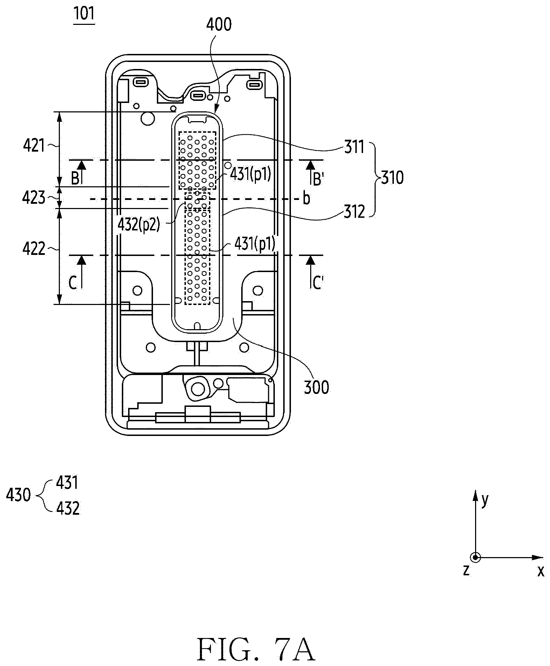

For example, since the second portion 312 includes the slit 312a, it may emit heat transferred from the vapor chamber 400 through the slit 312a. For example, the slit 312a may be disposed under the vapor chamber 400. A portion of the vapor chamber 400 may face a component (e.g., a battery 270 of FIG. 3) of the electronic device 101 disposed under the slit 312a through the slit 312a. For example, the second portion 312 may include a second supporting structure 312b supporting the vapor chamber 400 so that the vapor chamber 400 does not pass through the slit 312a. Regarding that the second supporting structure 312b supports the vapor chamber 400, it will be described later with reference to FIGS. 7A to 7C.

For example, the heat emitted from the processor 120 may be transferred to the vapor chamber 400 in the +z direction through the first portion 311 of the seating groove 310. The heat transferred to the vapor chamber 400 may be diffused in the -y direction within the vapor chamber 400. The heat diffused in the -y direction may be emitted through the slit 312a of the second portion 312 in the -z direction. However, it is not limited thereto. By including the seating groove 310 accommodating the vapor chamber 400, the electronic device 101 may provide an additional space in which another electronic component may be mounted inside the electronic device 101 and may transfer the heat emitted from the processor 120 to the vapor chamber 400.

According to an embodiment, the vapor chamber 400 may include a first plate 410. The first plate 410 may include a base 411 supported by the first portion 311 of the seating groove 310 and at least a portion thereof disposed on the slit 312a, and a sidewall 412 extending from a periphery of the base 411 toward the outside of the seating groove 310.

For example, the base 411 may be supported by the first supporting structure 311a of the first portion 311. Since the base 411 contacts the first portion 311, the heat emitted from the processor 120 may be transferred through the first portion 311. For example, a portion of the base 411 may contact the first supporting structure 311a of the first portion 311, and a remaining portion of the base 411 may face the slit 312a of the second portion 312. The remaining portion of the base 411 may be exposed to the outside of the seating groove 310 through the slit 312a. The portion of the base 411 may receive heat from the processor 120 through the first supporting structure 311a. The remaining portion of the base 411 may emit heat from the vapor chamber 400 through the slit 312a. For example, the sidewall 412 may be connected to the base 411. The side wall 412 may face an inner surface of the seating groove 310. A height of the sidewall 412 may be substantially the same as a depth of the seating groove 310.

The first plate 410 has been described as including the base 411 supported by the first portion 311 of the seating groove 310 and the sidewall 412 extending from the periphery of the base 411, but is not limited thereto. For example, the first plate 410 may be the base 411 supported by the first portion 311. The second plate 420 contacting the first plate 410 may be configured to form an inner space S of the vapor chamber 400, by including a portion extending from at least a portion of the second plate 420 to the first plate 410 and supported by the first plate 410. For example, the first plate 410 may be the base 411 spaced apart from the second plate 420. The sidewall 412 may be a separate plate that surrounds a space between the first plate 410 and the second plate 420 and extends from the first plate 410 to the second plate 420. However, it is not limited thereto, and the vapor chamber 400 may include a structure forming the inner space S in the seating groove 310.

According to an embodiment, the vapor chamber 400 may include a second plate 420 contacting a portion of the sidewall 412 of the first plate 410. The second plate 420 may be coupled to the first plate 410. The second plate 420 may cover the seating groove 310.

According to an embodiment, the second plate 420 may include a first region 421 disposed on the first portion 311 of the seating groove 310, a second region 422 disposed on the slit 312a of the second portion 312 extending from the first portion 311, and a third region 423 extending from the first region 421 to the second region 422 and located on the boundary b between the first portion 311 and the second portion 312. In the present document, when an element is referred to as being "on" another element, it should be understood that it is directly on the other element or intervening elements may exist therebetween. For example, in the present document, "B disposed on A" may indicate "B disposed over A". For example, in the present document, "B disposed on A" may indicate "B faced away from A".

For example, when viewing the vapor chamber 400 from above, the first region 421 may overlap the first portion 311 and/or the processor 120. The second region 422 may overlap the slit 312a of the second portion 312. The third region 423 may overlap the boundary b between the first portion 311 and the second portion 312.

For example, the slit 312a may extend from the first supporting structure 311a of the first portion 311 supporting at least a portion of the base 411. The boundary b between the first portion 311 and the second portion 312 may include a boundary between the first supporting structure 311a and the slit 312a. The third region 423 may be a region disposed on the boundary between the first supporting structure 311a and the slit 312a.

According to an embodiment, the second plate 420 may include a plurality of pillars 430 protruding toward the base 411 of the first plate 410 and including an end 430a having a flat shape at a position adjacent to the base 411. For example, each of the plurality of pillars 430 may have a flat shape parallel to the base 411 at the position adjacent to the base 411. For example, each of the plurality of pillars 430 may include a dome shape, but is not limited thereto. For example, when the electronic device 101 receives an impact from the outside, the second plate 420 may temporarily move toward the base 411. Since the plurality of pillars 430 have a flat shape at the position adjacent to the base 411, when the second plate 420 moves, the plurality of pillars 430 may increase a supporting area for supporting the second plate 420. The plurality of pillars 430 may reduce damage (e.g., folding) of the second plate 420 due to external impact of the electronic device 101 by increasing the supporting area. The plurality of pillars 430 may be formed through a press process of the second plate 420, but is not limited thereto.

According to an embodiment, the vapor chamber may further include an inner space S including a fluid (not illustrated) covered by the first plate 410 and the second plate 420, and a wick 450 for moving the fluid in a liquid state and contacting the base 411 in the inner space S. The first plate 410 may be configured to seal the space S together with the second plate 420. The fluid disposed in the inner space S of the vapor chamber 400 may be vaporized by the heat transferred from the processor 120. According to an embodiment, the vapor chamber 400 may include at least one of stainless steel and titanium, but is not limited thereto.

For example, the air pressure of the inner space S of the vapor chamber 400 may be lower than atmospheric pressure. For example, the air pressure of the inner space S of the vapor chamber 400 may be substantially in a vacuum state. The fluid may be, for example, water, but is not limited thereto. For example, the wick 450 may be supported by the base 411 in the inner space S. The wick 450 may transfer the fluid in the liquid state from the inner space S to a portion close to the processor 120. For example, the wick 450 may include a porous structure for absorbing fluid in the vapor chamber 400, but is not limited thereto. For example, when the heat from the processor 120 is transferred to the wick 450 through the base 411, the fluid in the liquid state in the wick 450 may be vaporized. As the fluid vaporized from the wick 450 diffuses into the inner space S of the vapor chamber 400, the heat from the processor 120 may be dispersed. For example, as the heat from the vapor chamber 400 is emitted through the slit 312a of the seating groove 310, the fluid adjacent to the slit 312a may be cooled. The fluid liquefied by cooling may be absorbed by the wick 450.

For example, a portion of the sidewall 412 of the first plate 410 may seal the inner space S of the vapor chamber 400, by contacting the second plate 420. The sidewall 412 may seal the inner space S by being welded to the second plate 420, but is not limited thereto.

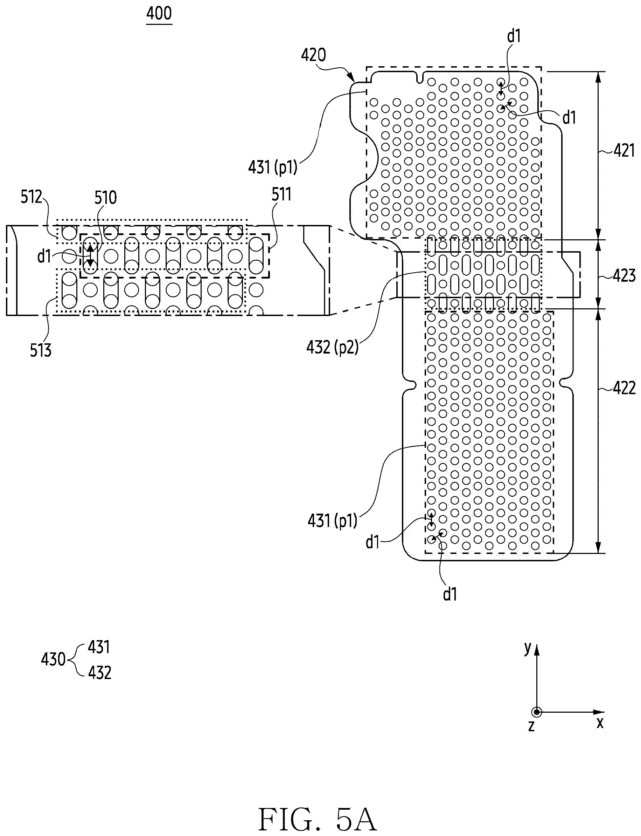

According to an embodiment, the second plate 420 may include the plurality of pillars 430 including the end 430a protruding toward the base 411 of the first plate 410 and having the flat shape at the position adjacent to the base 411. The plurality of pillars 430 may include a first set of pillars 431 having a first pattern p1 in the first region 421 and the second region 422 and a second set of pillars 432 having a second pattern p2 different from the first pattern p1 in the third region 423. For example, each of the first region 421, the second region 422, and the third region 423 may include a plurality of pillars having a flat shape at positions adjacent to the base 411. The pillars included in each of the first region 421 and the second region 422 may be disposed to have the first pattern p1. The pillars included in the third region 423 may be disposed to have the second pattern p2 different from the first pattern p1. Regarding that the second pattern p2 is different from the first pattern p1, it will be described later with reference to FIGS. 5A to 6B. Since the second pattern p2 is different from the first pattern p1, the vapor chamber 400 may reduce damage due to external impact of the third region 423 disposed on the boundary b between the first portion 311 and the second portion 312. According to an embodiment, a rigidity of the third region 423 may be greater than a rigidity of the first region 421 and a rigidity of the second region 422. For example, the second set of pillars 432 included in the third region 423 may be configured such that the rigidity of the third region 423 is greater than the rigidity of the first region 421 and the second region 422 by having the second pattern p2 different from the first pattern p1 of the first set of pillars 431 included in the first region 421 and the second region 422.

According to the above-described embodiment, the electronic device 101 may reduce damage of the electronic device 101 due to the heat, by including the vapor chamber 400 dispersing the heat emitted from the processor 120 in the electronic device 10. The electronic device 101 may provide additional space for electronic components within the electronic device 101 and may help heat transfer from the vapor chamber 400, by including the seating groove 310 accommodating at least a portion of the vapor chamber 400. The second plate 420 of the vapor chamber 400 may reduce damage of the second plate 420 due to the external impact, by including the plurality of pillars 430 having the flat shape at the position adjacent to the base 411 of the first plate 410. The second set of pillars 432 in the third region 423 of the second plate 420 may reduce damage of the third region 423 due to the external impact, by having a different pattern from the first set of pillars 431 in the first region 421 and the third region 423.

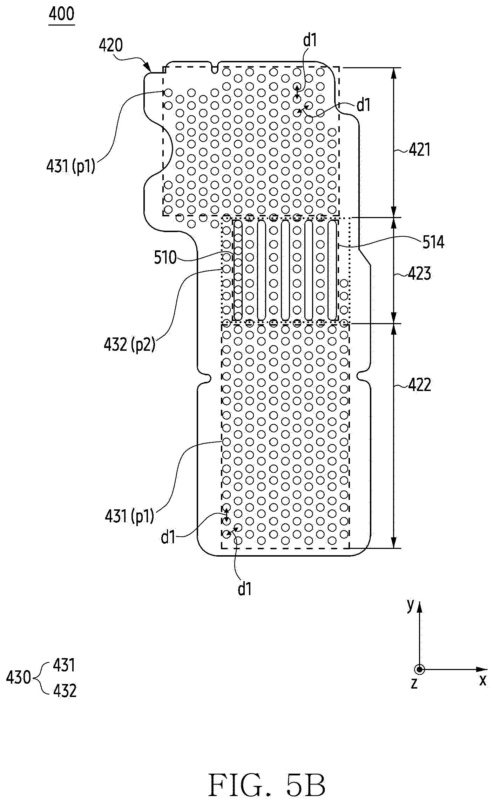

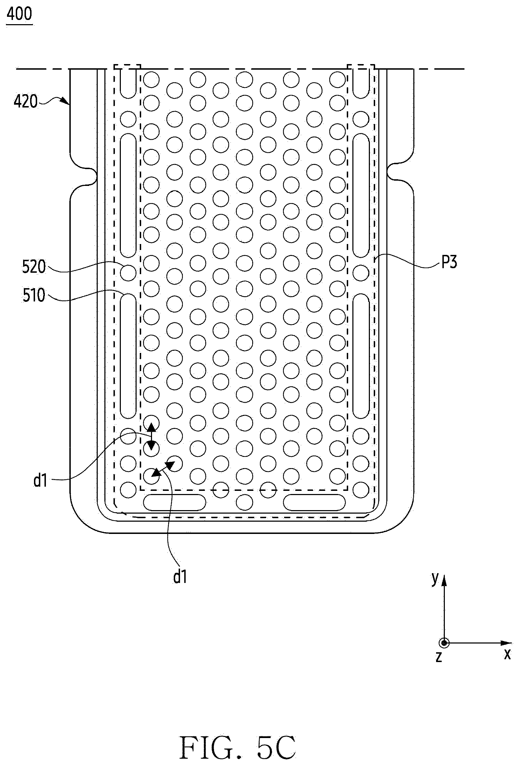

FIGS. 5A, 5B, and 5C illustrate a portion of an exemplary vapor chamber.

Referring to FIGS. 5A, 5B, and 5C, a second plate 420 of a vapor chamber 400 may include a first region 421, a second region 422, a third region 423, and a plurality of pillars 430. The plurality of pillars 430 may include a first set of pillars 431 having a first pattern p1 in the first region 421 and the second region 422 and a second set of pillars 432 having a second pattern p2 different from the first pattern p1 in the third region 423. According to an embodiment, the first pattern p1 may have a shape in which each of the pillars included in the first set of pillars 431 within the first region 421 and the second region 422 is spaced apart from each other in a first distance d1. According to an embodiment, the first distance d1 may be located within a range of 2mm or more and 4mm or less, but is not limited thereto.

Hereinafter, redundant descriptions of the configurations described in FIGS. 4A to 4B will be omitted.

Referring to FIGS. 5A and 5B, the second pattern p2 includes at least one bead 510 to which at least a portion of the second set of pillars 432 is connected. For example, the at least one bead 510 may have a shape in which the at least a portion of the second set of pillars 432 in the third region 423 are connected to each other in an inner space (e.g., an inner space S of FIG. 4B) of the vapor chamber 400. For example, the at least one bead 510 may have a structure in which the at least a portion of the second set of pillars 432 are connected to each other through rivet bonding, but is not limited thereto. The third region 423 may reduce damage of the third region 423 due to external impact, by including the at least one bead 510 to which the at least a portion of the second set of pillars 432 are connected to the second pattern p2.

According to an embodiment, the at least one bead 510 may include a plurality of beads each having a length in the first direction (e.g., -y direction). The second pattern p2 may include a first set of beads 511 arranged in a second direction (e.g., +x direction) perpendicular to the first direction. The at least one bead 510 may help the fluid move in the vapor chamber 400 in the first direction by including the plurality of beads each having the length in the first direction, and may reduce the damage of the third region 423 from the external impact by including the first set of beads 511 arranged in the second direction perpendicular to the first direction. According to an embodiment, the third region 423 may include pillars each disposed between the beads included in the first set of beads 511. The pillars respectively disposed between the beads included in the first set of beads 511 may provide a movement path of fluid in the vapor chamber 400, by reinforcing a region between the beads and being spaced apart from each of the beads.

Referring to FIG. 5A, the third region 423 may include a second set of beads 512 and a third set of beads 513 spaced apart from the first set of beads 511. The first set of beads 511, the second set of beads 512, and the third set of beads 513 may form a pattern of a zigzag shape. Through the zigzag shape, the third region 423 may reduce the damage of the third region 423 due to the external impact.

According to an embodiment, the first pattern p1 may have a shape in which each of the first set of pillars 431 is spaced apart from each other in the first distance d1, and the at least one bead 510 may include two to eight pillars spaced apart from each other in the first distance d1 in the first direction (e.g., -y direction) of the second set of pillars 432. For example, referring to FIG. 5A, the at least one bead 510 may include two pillars spaced apart from each other in the first distance d1. The second pattern p2 may include the first set of beads 511 having the length in the first direction. For example, referring to FIG. 5B, the at least one bead 510 may include eight pillars spaced apart from each other in the first distance d1. The second pattern p2 may include a fourth set of beads 514 having the length in the first direction. Each of the beads included in the fourth set of beads 514 may have a length longer than the length of each of the beads included in the first set of beads 511, by including more pillars than each of the beads included in the first set of beads 511 of FIG. 5A. Each of the beads included in the fourth set of beads 514 may have a shape in which pillars spaced apart from each other, respectively, in a first distance d1 in the first direction are connected to each other. Each of the beads included in the fourth set of beads 514 may reduce the damage of the third region 423 from the external impact, by having the length longer than the length of each of the beads included in the first set of beads 511. By including the at least one bead 510 in a form in which the second pattern p2 includes two to eight pillars having the length in the first direction and spaced apart from each other in the first distance d1, the third region 423 may help the fluid move in the vapor chamber 400 in the first direction and may reduce the damage of the third region 423 due to the external impact.

Referring to FIG. 5C, the second plate 420 may further include a third pattern p3 including the at least one bead 510 connected to at least a portion of a plurality of pillars 430 disposed along a periphery of the second plate 420. According to an embodiment, the third pattern p3 may include a plurality of beads and at least one pillar 520 each disposed between the plurality of beads. The third pattern p3 may reduce occurrence of cracks at the periphery of the second plate 420 due to the external impact, by including the at least one bead 510 disposed along the periphery of the second plate 420. Since the fluid in the vapor chamber 400 is a fountain flow, the at least one bead 510 may reduce damage to the periphery of the second plate 420 without reducing heat diffusion by the fluid by being disposed on the periphery of the second plate 420. The third pattern p3 may be configured to emit heat from the vapor chamber 400 between the plurality of beads, by including the at least one pillar 520 each disposed between the plurality of beads. According to an embodiment, the third pattern p3 may be located in the first region 421 and/or the second region 422. According to an embodiment, the third pattern p3 may be located in the first region 421, the second region 422, and/or the third region 423.

According to the above-described embodiment, the vapor chamber 400 may reduce damage of the third region 423 due to the external impact, by including the at least one bead 510 in which at least a portion of the second set of pillars 432 are connected to each other in the third region 423 of the second plate 420. The third region 423 may help the fluid move, by having a length in the direction (e.g., -y direction) in which the fluid in the vapor chamber 400 moves.

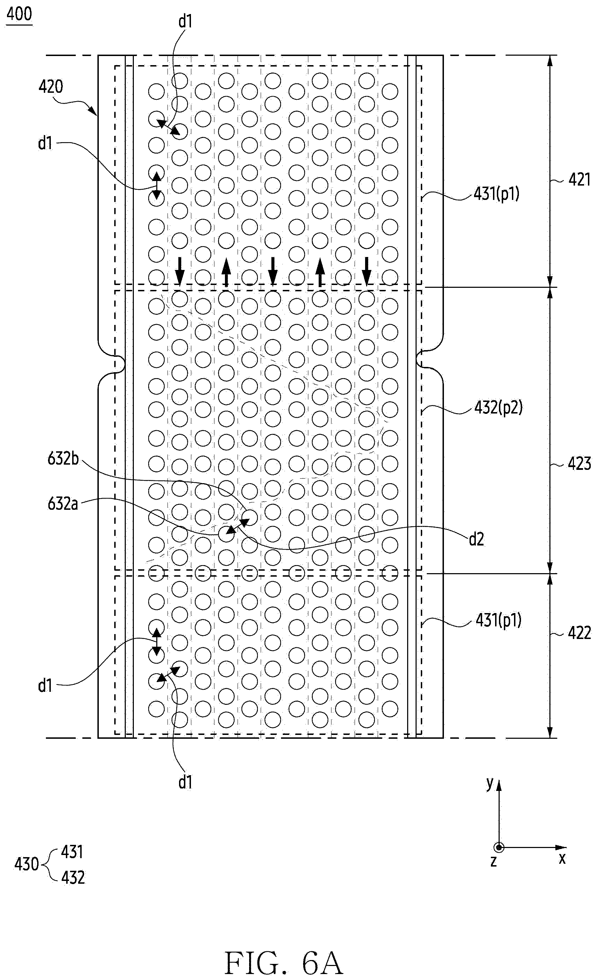

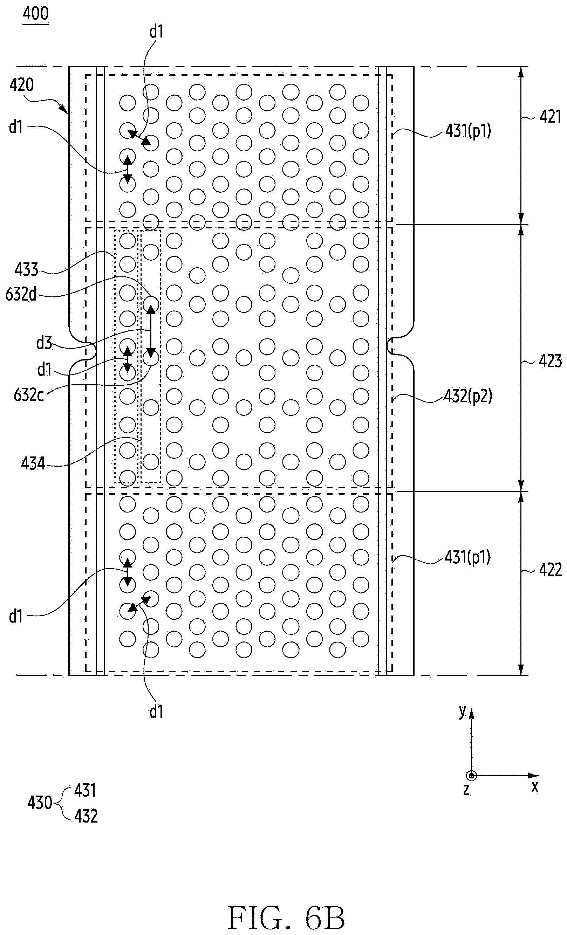

FIGS. 6A and 6B illustrate a portion of an exemplary vapor chamber.

Referring to FIGS. 6A and 6B, a second plate 420 of a vapor chamber 400 may include a first region 421, a second region 422, a third region 423, and a plurality of pillars 430. The plurality of pillars 430 may include a first set of pillars 431 having a first pattern p1 in the first region 421 and the second region 422 and a second set of pillars 432 having a second pattern p2 different from the first pattern p1 in the third region 423. The first pattern p1 may have a shape in which each of the first set of pillars 431 is spaced apart from each other in a first distance d1.

According to an embodiment, the second pattern p2 may have a shape in which each of the pillars included in the second set of pillars 432 is spaced apart from each other at various distances. The second pattern p2 may reduce damage (e.g., folding) of the third region 423 due to external impact, by including the shape in which each of the pillars included in the second set of pillars 432 is spaced apart from each other at various distances. For example, unlike the first set of pillars 431 having the first pattern p1 is regularly arranged, the second set of pillars 432 having the second pattern p2 may be arranged irregularly.

For example, referring to FIG. 6A, the second pattern p2 may have a shape in which one pillar 632a among the second set of pillars 432 is spaced apart from another pillar 632b most adjacent to the one pillar 632a in a second distance d2 smaller than the first distance d1. For example, the number of pillars per unit area of the second set of pillars 432 having the second pattern p2 may be greater than the number of pillars per unit area of the first set of pillars 431 having the first pattern p1. Since the second pattern p2 has the shape in which one pillar 632a among the second set of pillars 432 is spaced apart from another pillar 632b most adjacent to the one pillar 632a in the second distance d2 smaller than the first distance d1, the third region 423 may reduce damage of the third region 423 from the external impact.

For example, referring to FIG. 6B, the second pattern p2 may have a shape in which one pillar 632c among the second set of pillars 432 is spaced apart in a third distance d3 greater than the first distance d1 from the farthest other one pillar 632d among pillars surrounding the one pillar 632c. For example, the number of pillars per unit area of the second set of pillars 432 having the second pattern p2 may be less than the number of pillars per unit area of the first set of pillars 431 having the first pattern p1. For example, the third region 423 may be a flow bottleneck in a path through which the fluid in the vapor chamber 400 moves. Since the second pattern p2 has the shape in which one pillar 632c among the second set of pillars 432 is spaced apart in the third distance d3 greater than the first distance d1 from the farthest other one pillar 632d among pillars surrounding the one pillar 632c, the third region 423 may help fluid in the vapor chamber 400 move.

According to an embodiment, the second set of pillars 432 may include a third set of pillars 433 spaced apart from each other in the first distance d1 in the first direction (e.g., -y direction) in the second pattern p2, and a fourth set of pillars 434 disposed in a second direction (e.g., +x direction) perpendicular to the first direction with respect to the third set of pillars 433 and spaced apart from each other in the first direction in the third distance d3 greater than the first distance d1, in the second pattern p2. As the pillars included in the third set of pillars 433 and the pillars included in the fourth set of pillars 434 are spaced apart from each other, respectively, in different distances, the third region 423 may reduce bending of the third region 423 due to the external impact and may help the movement of the fluid in the vapor chamber 400.

According to the above-described embodiment, the vapor chamber 400 may reduce the damage of the third region 423 from the external impact as the second pattern p2 included in the third region 423 is different from the first pattern p1 included in each of the first region 421 and the second region 422, or may help the movement of the fluid in the vapor chamber 400 moving through the third region 423 by including irregularly arranged pillars.

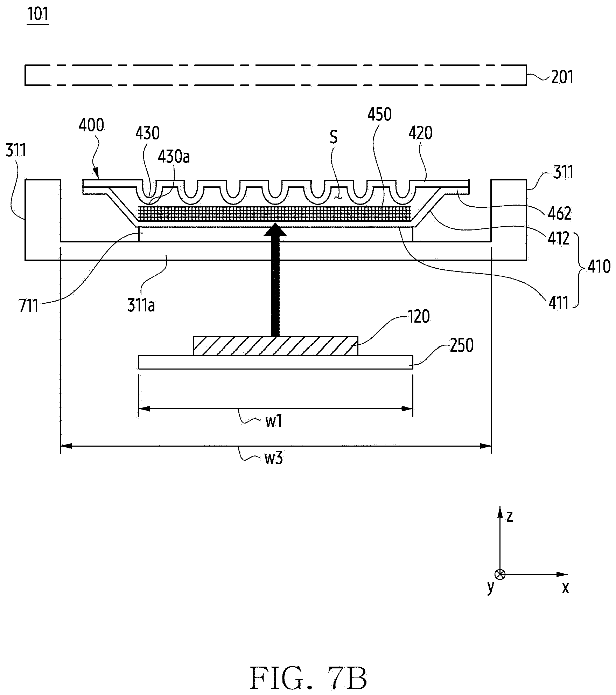

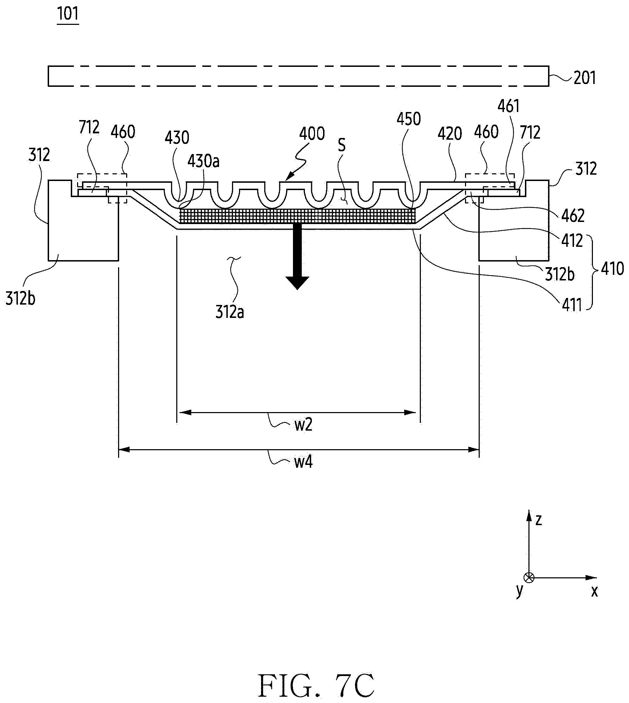

FIG. 7A illustrates the inside of an exemplary electronic device in which a vapor chamber is disposed. FIG. 7B is a cross-sectional view of an exemplary electronic device cut along line B-B' of FIG. 7A. FIG. 7C is a cross-sectional view of an exemplary electronic device cut along line C-C' of FIG. 7A.

Referring to FIGS. 7A, 7B, and 7C, an electronic device 101 may be spaced apart from a printed circuit board 250, a processor 120 on the printed circuit board 250, and a vapor chamber 400 spaced apart from the printed circuit board 250 and at least partially overlapping the processor 120 when viewed from above. The electronic device 101 may include a metal plate 300 on the printed circuit board 250 supporting the vapor chamber 400. The metal plate 300 may include a first portion 311 on the processor 120 for transferring heat emitted from the processor 120 to the vapor chamber 400 and a second portion 312 extending from the first portion 311 and having a slit 312a formed therein, and may include a seating groove 310 in which at least a portion of the vapor chamber 400 is accommodated. The vapor chamber 400 may include a first plate 410 and a second plate 420. The first plate 410 may include a base 411 supported by the first portion 311 of the seating groove 310 and having at least a portion disposed on the slit 312a and a sidewall 412 extending from a periphery of the base 411 toward the outside of the seating groove 310. The second plate 420 may include a first region 421 contacting the sidewall 412 and disposed on the first portion 311, a second region 422 disposed on the slit 312a of the second portion 312, a third region 423 extending from the first region 421 to the second region 422 and located on the boundary b between the first region 311 and the second region 312, and a plurality of pillars 430 protruding toward the base 411 and including an end having a flat shape at a position adjacent to the base 411. The plurality of pillars 430 may include a first set of pillars 431 having a first pattern p1 in the first region 421 and the second region 422 and a second set of pillars 432 having a second pattern p2 different from the first pattern p1 in the third region 423.

It has been described that the first region 421 and the second region 422 include the first set of pillars 431 having the first pattern p1, but it is not limited thereto. The pillars included in the first region 421 may have a different pattern from the pillars included in the second region 422. The pillars included in the third region 423 may be configured to reduce damage of the third region 423 due to external impact by having a pattern different from the pattern of the pillars included in the first region 421 and the pattern of the pillars included in the second region 422.

According to an embodiment, the electronic device 101 may further include a display 201. The vapor chamber 400 may be disposed under the display 201. One surface of the metal plate 300 on which the seating groove 310 accommodating the at least a portion of the vapor chamber 400 is formed may face the display 201. The electronic device 101 may reduce damage to the display 201 due to the heat emitted from the processor 120, by including the vapor chamber 400 and the metal plate 300 between the processor 120 and the display 201.

According to an embodiment, the first portion 311 of the seating groove 310 may include a first supporting structure 311a supporting the first plate 410. The second portion 312 of the seating groove 310 may include a second supporting structure 312b protruding from an inner surface of the seating groove 310 and disposed along a periphery of the slit 312a. The vapor chamber 400 may further include a flange portion 460 disposed along a periphery of the vapor chamber 400 and supporting the vapor chamber 400 through the second supporting structure 312b.

For example, the first supporting structure 311a may support the first plate 410 including the base 411 by supporting at least a portion of the base 411. For example, the first supporting structure 311a may be a path through which the heat emitted from the processor 120 is transferred to the first plate 410. For example, the second supporting structure 312b may extend from the first supporting structure 311a and/or the periphery of the slit 312a. For example, the second supporting structure 312b may be configured so that the vapor chamber 400 may be supported by the metal plate 300 without being separated from the seating groove 310 by the slit 312a, by supporting a portion of the sidewall 412 of the first plate 410 and/or a portion of the second plate 420.

For example, the flange portion 460 may be a portion of the vapor chamber 400 supported by the second supporting structure 312b. For example, the flange portion 460 may be a portion overlapping the second supporting structure 312b when viewing the metal plate 300 from above. For example, the flange portion 460 may be a portion extending from a periphery of the second plate 420 and/or a periphery of the first plate 410 toward the outside of the seating groove 310. For example, the flange portion 460 may be a portion extending in a direction parallel to the direction in which the second plate 420 extends from the periphery of the vapor chamber 400. The vapor chamber 400 may be configured such that the vapor chamber 400 is supported by the metal plate 300 in the second region 321 including the slit 312a, by including the flange portion 460 supporting the vapor chamber 400 through the second supporting structure 312b.

According to an embodiment, a width w1 of the base 411 disposed on the first portion 311 may be greater than a width w2 of the base 411 disposed on the second portion 312. For example, since a portion of the vapor chamber 400 disposed in the first portion 311 is supported by the first supporting structure 311a, it may not include the flange portion 460. Since the portion of the vapor chamber 400 does not include the flange portion 460, a width w3 of the first portion 311 for accommodating the portion of the vapor chamber 400 may be greater than a width w4 of the second portion 312 including the second supporting structure 312b. Since the width w3 of the first portion 311 of the seating groove 310 accommodating the vapor chamber 400 is greater than the width w4 of the second portion 312, the width w1 of the base 411 disposed on the first portion 311 may be greater than the width w2 of the base 411 disposed on the second portion 312.

For example, a portion of the vapor chamber 400 disposed on the first portion 311 may increase an inner space S of the vapor chamber 400, by not including the flange portion 460. A width of a wick 450 contacting the base 411 disposed on the first portion 311 may be greater than that of the case including the flange portion 460. The first set of pillars 431 disposed on the first region 421 of the second plate 420 may increase as the inner space S of the vapor chamber 400 increases. As the inner space S of the vapor chamber 400 increases, the vapor chamber 400 may provide an additional space capable of operating to the fluid in the inner space S. The vapor chamber 400 may increase the diffusion speed of the heat transferred from the processor 120 by providing the additional space.

According to an embodiment, the flange portion 460 may include a first protrusion 461 extending from at least a portion of the second region 422 and the third region 423 of the second plate 420, and a second protrusion 462 extending from a periphery of the sidewall 412 of the first plate 410 and supporting the first protrusion 461. For example, the first protrusion 461 may extend in the direction parallel to the direction in which the second plate 420 extends. The second protrusion 462 may extend along the first protrusion 461 in the direction parallel to the direction in which the second plate 420 extends. The sidewall 412 may be configured to support the second plate 420 and to seal the inner space S of the vapor chamber 400, by including the second protrusion 462. The second plate 420 may increase a contact surface of the flange portion 460 with the second supporting structure 312b, by including the first protrusion 461.

It was described that the first portion 311 disposed on the processor 120 includes the first supporting structure 311a supporting the first plate 410 and the second portion 312 extending from the first portion 311 includes the slit 312a, thereby providing the second supporting structure 312b supporting the flange portion 460, but is not limited thereto.

Although not illustrated, unlike those illustrated in FIGS. 7B and 7C, the first portion 311 may include a slit configured such that at least a portion (e.g., the base 411) of the first plate 410 faces the processor 120. The first portion 311 may further include a heat transfer material disposed in the slit for heat transfer from the processor 120 to the vapor chamber 400. The vapor chamber 400 disposed on the first portion 311 may be supported by the first portion 311 by including a flange portion. Unlike those illustrated in FIGS. 7B and 7C, the second portion 312 extending from the first portion 311 may support at least a portion of the first plate 410, by not including the slit 312a. The second portion 312 may provide an additional space in the inner space S of the vapor chamber 400, by not including the flange portion. Heat transferred from the processor 120 to the vapor chamber 400 through the slit may reduce damage to electronic components (e.g., the display 201) disposed on the vapor chamber 400, by diffusing to the metal plate 300 by the vapor chamber 400. However, it is not limited thereto.

According to an embodiment, the electronic device 101 may further include a first adhesive member 711 disposed between the base 411 and the first supporting structure 311a, and a second adhesive member 712 disposed between the flange portion 460 and the second supporting structure 312b. By including the first adhesive member 711 and the second adhesive member 712, the electronic device 101 may fasten the vapor chamber 400 to the metal plate 300 and may reduce separation of the vapor chamber 400 from the seating groove 310.

According to an embodiment, the first adhesive member 711 and/or the second adhesive member 712 may include a material having high thermal conductivity for heat transfer between the vapor chamber 400 and the metal plate 300. For example, it may include at least one of a thermal tape and a thermal pad, but is not limited thereto.

According to the above-described embodiment, the electronic device 101 may reduce separation of the vapor chamber 400 from the metal plate 300, by including the first supporting structure 311a and the second supporting structure 312b. The vapor chamber 400 may be configured such that the vapor chamber 400 is not separated through the slit 312a, by including the flange portion 460 supported by the second supporting structure 312b. The vapor chamber 400 may increase the inner space S in which the fluid in the vapor chamber 400 operates without including the flange portion 460 in a portion of the vapor chamber 400 disposed on the first portion 311 of the settling groove 310.

According to the above-described embodiment, an electronic device (e.g., an electronic device 101 of FIG. 1) may comprise a printed circuit board (e.g., a first printed circuit board 250 of FIG. 3), a processor (e.g., a processor 120 of FIG. 1) on the printed circuit board, and a vapor chamber (e.g., a vapor chamber 400 of FIG. 4A) spaced apart from the printed circuit board and at least partially disposed over the processor. The electronic device may comprise a metal plate (e.g., a metal plate 300 of FIG. 4A), disposed on the printed circuit board, including a seating groove including a first portion (e.g., a first portion 311 of FIG. 4A) on the processor for supporting the vapor chamber and transferring heat emitted from the processor to the vapor chamber and a second portion (e.g., a second portion 312 of FIG. 4A ) extending from the first portion and having a slit (e.g., a slit 312a of FIG. 4A) formed therein and a seating groove (e.g., a seating groove 310 of FIG. 4A) in which at least a portion of the vapor chamber is accommodated. The vapor chamber may include a first plate (e.g., a first plate 410 of FIG. 4A) including a base (e.g., a base 411 of FIG. 4B) supported by the first portion of the seating groove and having at least a portion disposed on the slit, and a sidewall (e.g., a sidewall 412 of FIG. 4B) extending from a periphery of the base toward an outside of the seating groove. The vapor chamber may include a second plate (e.g., a second plate 420 of FIG. 4A) contacting the sidewall and including a first region (e.g., a first region 421 of FIG. 4A) disposed on the first portion, a second region (e.g., a second region 422 of FIG. 4A) disposed on the slit of the second portion, a third region (e.g., a third region 423 of FIG. 4A) extending from the first region to the second region and located on the boundary (e.g., a boundary b of FIG. 4A) between the first portion and the second portion, and a plurality of pillars (e.g., a plurality of pillars 430 of FIG. 4A ) protruding toward the base and including an end (e.g., an end 430a of FIG. 4B) having flat shape at a position adjacent to the base. The plurality of pillars may include a first set of pillars (e.g., a first set of pillars 431 of FIG. 4A) having a first pattern (e.g., a first pattern p1 of FIG. 4A) in the first region and the second region, and a second set of pillars (e.g., a second set of pillars 432 of FIG. 4A ) having a second pattern (e.g., a second pattern p2 of FIG. 4A) different from the first pattern in the third region. According to the above-mentioned embodiment, the electronic device may diffuse heat emitted from the processor by including the vapor chamber. The vapor chamber may reduce damage to the third region due to external impact by including the first set of pillars having the first pattern in the first region and in the second region and the second set of pillars having the second pattern different from the first pattern in the third region. The above-mentioned embodiment may have various effects including the above-mentioned effects.

According to an embodiment, the second pattern may include at least one bead (e.g., at least one bead 510 of FIG. 5A) to which at least some of the second set of pillars are connected. According to the above-mentioned embodiment, the second pattern may reduce the damage to the third region due to the external impact by including the at least one bead. The above-mentioned embodiment may have various effects including the above-mentioned effects.

According to an embodiment, the at least one bead may include a plurality of beads each having a length in the first direction, and the second pattern may include a set of beads (e.g., a first set of beads 511, a second set of beads 512, a third set of beads 513 of FIG. 5A) arranged in a direction perpendicular to the first direction. According to the above-mentioned embodiment, the second pattern may help movement of the fluid in the vapor chamber moving in the first direction and may reduce the damage to the third region due to the external impact, by including the set of beads arranged in a direction perpendicular to the first direction. The above-mentioned embodiment may have various effects including the above-mentioned effects.

According to an embodiment, the first pattern may have a shape in which each of the first set of pillars spaced apart from each other in a first distance d1 (e.g., the first distance d1 of FIG. 5A), and the at least one bead may include two to eight pillars spaced apart from each other in the first distance in the first direction among the second set of pillars. According to the above-mentioned embodiment, the at least one bead may help the movement of the fluid in the vapor chamber moving in the first direction and may reduce the damage to the third region due to the external impact, by including two to eight pillars spaced apart from each other in the first distance in the first direction among the second set of pillars. The above-mentioned embodiment may have various effects including the above-mentioned effects.

According to an embodiment, the first pattern may have a shape in which each of the first set of pillars spaced apart from each other in the first distance d1, and the second pattern may have a shape in which one pillar (e.g., one pillar 632a of FIG. 6A) among the second set of pillars spaced apart in a second distance (e.g., a second distance d2 of FIG. 6A) smaller than the first distance from another pillar (e.g., another pillar 632b of FIG. 6A) closest to the one pillar. According to the above-mentioned embodiment, the second pattern may reduce the damage to the third region due to the external impact, by having the shape in which one pillar among the second set of pillars spaced apart in the second distance smaller than the first distance from another pillar closest to the one pillar. The above-mentioned embodiment may have various effects including the above-mentioned effects.

According to an embodiment, the first pattern may have the shape in which each of the first set of pillars spaced apart from each other in the first distance d1, and the second pattern may have a shape in which one pillar (e.g., one pillar 632c of FIG. 6B) among the second set of pillars spaced apart in a third distance (e.g., a third distance d3 of FIG. 6B) greater than the first distance from another pillar (e.g., another pillar 632d of FIG. 6B) farthest to the one pillar among pillars surrounding the one pillar. According to the above-mentioned embodiment, the second pattern may help the movement of the fluid in the vapor chamber passing through the third region, by having the shape in which one pillar among the second set of pillars spaced apart in the third distance greater than the first distance from another pillar farthest to the one pillar among pillars surrounding the one pillar. The above-mentioned embodiment may have various effects including the above-mentioned effects.

According to an embodiment, the first pattern may have a shape in which each of the first set of pillars spaced apart from each other in the first distance d1. The second set of pillars may include a third set of pillars (e.g., a third set of pillars 433 of FIG. 6B) spaced apart from each other in the first distance in a first direction in the second pattern, and a fourth set of pillars spaced apart from each other in a third distance in the first direction greater than the first distance and disposed in a second direction perpendicular to the first direction with respect to the third set of pillars in the second pattern. According to the above-mentioned embodiment, the second set of pillars may help the movement of the fluid in the vapor chamber passing through the third region, by including the third set of pillars and the fourth set of pillars. The above-mentioned embodiment may have various effects including the above-mentioned effects.

According to an embodiment, a rigidity of the third region may be greater than a rigidity of the first region and the rigidity of the second region. According to the above-mentioned embodiment, as the rigidity of the third region is greater than the rigidity of the first region and the rigidity of the second region, the vapor chamber may reduce the damage to the third region due to the external impact. The above-mentioned embodiment may have various effects including the above-mentioned effects.

According to an embodiment, the second plate may include a third pattern (e.g., a third pattern p3 of FIG. 5C) including at least one bead to which at least some of the plurality of pillars disposed along a periphery of the second plate are connected. According to the above-mentioned embodiment, the second plate may reduce damage to the periphery of the second plate due to the external impact, by including the third pattern. The above-mentioned embodiment may have various effects including the above-mentioned effects.

According to an embodiment, the first portion may include a first supporting structure (e.g., a first supporting structure 311a of FIG. 4A) supporting the first plate, and the second portion may include a second supporting structure (e.g., a second supporting structure 312b of FIG. 4B) protruding from an inner surface of the seating groove and disposed along a periphery of the slit. The vapor chamber may further include a flange portion (e.g., a flange portion 460 of FIG. 7C) disposed along a periphery of the vapor chamber and supporting the vapor chamber through the second supporting structure. According to the above-mentioned embodiment, the seating groove may support the vapor chamber by including the first supporting structure and the second supporting structure. The vapor chamber may reduce separation of the vapor chamber from the metal plate by including the flange portion. A portion of the vapor chamber disposed on the first portion may provide an additional space in a space in which the fluid of the vapor chamber operates by not including the flange portion. The above-mentioned embodiment may have various effects including the above-mentioned effects.

According to an embodiment, the flange portion may include a first protrusion (e.g., a first protrusion 461 of FIG. 7C) extending from at least a portion of the second region and the third region of the second plate and a second protrusion (e.g., a second protrusion 462 of FIG. 7C) extending from a periphery of the sidewall of the first plate and supporting the first protrusion. According to the above-mentioned embodiment, the flange portion may reduce the separation of the vapor chamber from the metal plate by including the first protrusion and the second protrusion. The above-mentioned embodiment may have various effects including the above-mentioned effects.

The electronic device according to an embodiment may further comprise a first adhesive member (e.g., a first adhesive member 711 of FIG. 7C) disposed between the base and the first supporting structure and a second adhesive member (e.g., a second adhesive member 712 of FIG. 7C) disposed between the flange portion and the second supporting structure. According to the above-mentioned embodiment, the electronic device may reduce separation of the vapor chamber from the seating groove by including the first adhesive member and the second adhesive member. The above-mentioned embodiment may have various effects including the above-mentioned effects.

According to an embodiment, the vapor chamber may further include a space (e.g., an inner space S of FIG. 4B) covered by the first plate and the second plate and including a fluid, and a wick (e.g., a wick 450 of FIG. 4B) for moving the fluid in a liquid state and contacting the base in the space. The first plate may be configured to seal the space together with the second plate. According to the above-mentioned embodiment, the vapor chamber may circulate the fluid by including the wick. The first plate may prevent separation of the fluid in the space by sealing the space together with the second plate. The above-mentioned embodiment may have various effects including the above-mentioned effects.

According to an embodiment, a width (e.g., a width w1 of FIG. 7B) of the base disposed on the first portion may be greater than a width (e.g., a width w2 of FIG. 7C) of the base disposed on the second portion. According to the above-mentioned embodiment, as the width of the base disposed on the first portion is greater than the width of the base disposed on the second portion, the vapor chamber may provide an additional space in the space in which the fluid in the vapor chamber operates. The above-mentioned embodiment may have various effects including the above-mentioned effects.

According to an embodiment, the vapor chamber may further include at least one of stainless steel, and titanium. According to the above-mentioned embodiment, the vapor chamber may increase the diffusion speed of heat transferred to the vapor chamber by including the stainless steel. The above-mentioned embodiment may have various effects including the above-mentioned effects.

According to an embodiment, an electronic device may comprise a printed circuit board, a processor on the printed circuit board, and a vapor chamber spaced apart from the printed circuit board and at least partially disposed over the processor. The electronic device may comprise a metal plate, disposed on the printed circuit board, including a seating groove including a first portion on the processor for supporting the vapor chamber and transferring heat emitted from the processor to the vapor chamber and a second portion extending from the first portion and having a slit formed therein and a seating groove in which at least a portion of the vapor chamber is accommodated. The vapor chamber may include a first plate including a base supported by the first portion of the seating groove and having at least a portion disposed on the slit, and a sidewall extending from a periphery of the base toward an outside of the seating groove. The vapor chamber may include a second plate contacting the sidewall and including a first region disposed on the first portion, a second region disposed on the slit of the second portion, a third region extending from the first region to the second region and located on the boundary between the first portion and the second portion, and a plurality of pillars protruding toward the base and including an end having flat shape at a position adjacent to the base. The vapor chamber may further include at least one of stainless steel and titanium. The plurality of pillars may include a first set of pillars having a first pattern in the first region and the second region, and a second set of pillars having a second pattern different from the first pattern in the third region. A rigidity of the third region may be greater than a rigidity of the first region and a rigidity of the second region. According to the above-mentioned embodiment, the electronic device may diffuse heat emitted from the processor by including the vapor chamber. The vapor chamber may reduce damage to the third region due to external impact by including the first set of pillars having the first pattern in the first region and in the second region and the second set of pillars having the second pattern different from the first pattern in the third region. As the rigidity of the third region is greater than the rigidity of the first region and the rigidity of the second region, the vapor chamber may reduce the damage to the third region due to the external impact The above-mentioned embodiment may have various effects including the above-mentioned effects.

According to an embodiment, the second pattern may include at least one bead to which at least some of the second set of pillars are connected. According to the above-mentioned embodiment, the second pattern may reduce the damage to the third region due to the external impact by including the at least one bead. The above-mentioned embodiment may have various effects including the above-mentioned effects.

According to an embodiment, the first pattern may have a shape in which each of the first set of pillars spaced apart from each other in the first distance d1, and the second pattern may have a shape in which one pillar among the second set of pillars spaced apart in a second distance smaller than the first distance from another pillar closest to the one pillar. According to the above-mentioned embodiment, the second pattern may reduce the damage to the third region due to the external impact, by having the shape in which one pillar among the second set of pillars spaced apart in the second distance smaller than the first distance from another pillar closest to the one pillar. The above-mentioned embodiment may have various effects including the above-mentioned effects.

According to an embodiment, the first portion may include a first supporting structure supporting the first plate, and the second portion may include a second supporting structure protruding from an inner surface of the seating groove and disposed along a periphery of the slit. The vapor chamber may further include a flange portion disposed along a periphery of the vapor chamber and supporting the vapor chamber through the second supporting structure. According to the above-mentioned embodiment, the seating groove may support the vapor chamber by including the first supporting structure and the second supporting structure. The vapor chamber may reduce separation of the vapor chamber from the metal plate by including the flange portion. A portion of the vapor chamber disposed on the first portion may provide an additional space in a space in which the fluid of the vapor chamber operates by not including the flange portion. The above-mentioned embodiment may have various effects including the above-mentioned effects.

According to an embodiment, the vapor chamber may further include a space covered by the first plate and the second plate and including a fluid, and a wick for moving the fluid in a liquid state and contacting the base in the space. The first plate may be configured to seal the space together with the second plate. According to the above-mentioned embodiment, the vapor chamber may circulate the fluid by including the wick. The first plate may prevent separation of the fluid in the space by sealing the space together with the second plate. The above-mentioned embodiment may have various effects including the above-mentioned effects.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a printed circuit board (250);
a processor (120) on the printed circuit board (250);
a vapor chamber (400) spaced apart from the printed circuit board (250) and at least partially disposed over the processor (120); and
a metal plate (300), disposed on the printed circuit board (250), including a seating groove (310) in which at least a portion of the vapor chamber (400) is accommodated and including a first portion (311) on the processor (120) for transferring heat emitted from the processor (120) to the vapor chamber (400) and a second portion (312) extending from the first portion (311) and having a slit (312a) formed therein; and,
wherein, the vapor chamber (400) includes:
a first plate (410) including a base (411) supported by the first portion (311) of the seating groove (310) and having at least a portion disposed on the slit (312a), and a sidewall (412) extending from a periphery of the base (411) toward an outside of the seating groove (310); and
a second plate (420) contacting the sidewall (412) and including a first region (421) disposed on the first portion (311), a second region (422) disposed over the slit (312a) of the second portion (312), a third region (423) extending from the first region (421) to the second region (422) and located on the boundary (b) between the first portion (311) and the second portion (312), and a plurality of pillars (430) protruding toward the base (411) and including an end (430a) having flat shape at a position adjacent to the base (411); and,
wherein, the plurality of pillars (430) includes:
a first set of pillars (431) having a first pattern (p1) in the first region (421) and the second region (422); **characterised in that** the plurality of pillars (430) further includes
a second set of pillars (432) having a second pattern (p2) different from the first pattern (p1) in the third region (423), the second pattern (p2) including at least one bead (510) to which at least some of the second set of pillars (432) are connected.

2. The electronic device (101) of claim 1,
wherein the at least one bead (510) includes a plurality of beads each having a length in a first direction, and
wherein the second pattern (p2) includes a set of beads (511) arranged in a second direction perpendicular to the first direction.

3. The electronic device (101) of claim 1,
wherein the first pattern (p1) has a shape in which each of the first set of pillars (431) spaced apart from each other in a first distance (d1), and
wherein, the at least one bead includes two to eight pillars spaced apart from each other in the first distance in a first direction among the second set of pillars (432).

4. The electronic device (101) of any one of claims 1 to 3,
wherein the first pattern (p1) has a shape in which each of the first set of pillars (431) spaced apart from each other in a first distance (d1), and
wherein, the second pattern (p2) has a shape in which one pillar (632a) among the second set of pillars (432) spaced apart in a second distance (d2) smaller than the first distance (d1) from another pillar (632b) closest to the one pillar (632a).

5. The electronic device (101) of any one of claims 1 to 4,
wherein the first pattern (p1) has a shape in which each of the first set of pillars (431) spaced apart from each other in a first distance (d1), and
wherein the second pattern (p2) has a shape in which one pillar (632c) among the second set of pillars (432) spaced apart in a third distance (d3) greater than the first distance (d1) from another pillar (632d) farthest to the one pillar (632c) among pillars surrounding the one pillar (632c).

6. The electronic device (101) of any one of claims 1 to 5,
wherein the first pattern (p1) has a shape in which each of the first set of pillars (431) spaced apart from each other in a first distance (d1), and
wherein the second set of pillars (432) include:
a third set of pillars (433) spaced apart from each other in the first distance (d1) in a first direction in the second pattern (p2); and
a fourth set of pillars (434) spaced apart from each other in a third distance (d3) in the first direction greater than the first distance (d1) and disposed in a second direction perpendicular to the first direction with respect to the third set of pillars (433) in the second pattern (p2).

7. The electronic device (101) of any one of claims 1 to 6,
wherein a rigidity of the third region (423) is greater than a rigidity of the first region (421) and the rigidity of the second region (422).

8. The electronic device (101) of any one of claims 1 to 7,
wherein the second plate (420) further includes a third pattern (p3) including at least one bead (510) to which at least some of the plurality of pillars (430) disposed along a periphery of the second plate (420) are connected.

9. The electronic device (101) of any one of claims 1 to 8,
wherein the first portion (311) includes a first supporting structure (311a) supporting the first plate (410),
wherein the second portion (312) includes a second supporting structure (312b) protruding from an inner surface of the seating groove (310) and disposed along a periphery of the slit (312a), and
wherein the vapor chamber (400) further includes a flange portion (460) disposed along a periphery of the vapor chamber (400) and supporting the vapor chamber (400) through the second supporting structure (312b).

10. The electronic device (101) of claim 9,
wherein the flange portion (460) includes:
a first protrusion (461) extending from at least a portion of the second region (422) and the third region (423) of the second plate (420); and
a second protrusion (462) extending from a periphery of the sidewall (412) of the first plate (410) and supporting the first protrusion (461).

11. The electronic device (101) of claim 9 or 10, further comprising:
a first adhesive member (711) disposed between the base (411) and the first supporting structure (311a); and
a second adhesive member (712) disposed between the flange portion (460) and the second supporting structure (312b).

12. The electronic device (101) of any one of claims 1 to 11,
wherein the vapor chamber (400) further includes:
a space (S) covered by the first plate (410) and the second plate (420) and including a fluid; and
a wick (450) for moving the fluid in a liquid state and contacting the base (411) in the space (S); and,
wherein the first plate (410) is configured to seal the space (S) together with the second plate (420).

13. The electronic device (101) of any one of claims 1 to 12,
wherein a width (w1) of the base (411) disposed on the first portion (311) is greater than a width (w2) of the base (411) disposed on the second portion (312).

14. The electronic device (101) of any one of claims 1 to 13,
wherein the vapor chamber (400) further includes at least one of stainless steel, and titanium.

## Patentansprüche

1. Elektronische Vorrichtung (101), umfassend:
eine Leiterplatte (250);
einen Prozessor (120) auf der Leiterplatte (250);
eine Dampfkammer (400), die von der Leiterplatte (250) beabstandet und zumindest teilweise über dem Prozessor (120) angeordnet ist; und
eine Metallplatte (300), die auf der Leiterplatte (250) angeordnet ist und eine Setznut (310) beinhaltet, in der mindestens ein Abschnitt der Dampfkammer (400) untergebracht ist, und die einen ersten Abschnitt (311) auf dem Prozessor (120) zum Übertragen von Wärme, die von dem Prozessor (120) abgegeben wird, an die Dampfkammer (400) und einen zweiten Abschnitt (312), der sich von dem ersten Abschnitt (311) erstreckt und einen darin gebildeten Schlitz (312a) aufweist, beinhaltet; und
wobei die Dampfkammer (400) Folgendes beinhaltet:
eine erste Platte (410), die eine Basis (411), die von dem ersten Abschnitt (311) der Setznut (310) getragen wird und mindestens einen an dem Schlitz (312a) angeordneten Abschnitt aufweist, und eine Seitenwand (412), die sich von einem Umfang der Basis (411) zu einer Außenseite der Setznut (310) erstreckt, beinhaltet; und
eine zweite Platte (420), die die Seitenwand (412) berührt und einen ersten Bereich (421), der auf dem ersten Abschnitt (311) angeordnet ist, einen zweiten Bereich (422), der über dem Schlitz (312a) des zweiten Abschnitts (312) angeordnet ist, einen dritten Bereich (423), der sich von dem ersten Bereich (421) zu dem zweiten Bereich (422) erstreckt und sich an der Grenze (b) zwischen dem ersten Abschnitt (311) und dem zweiten Abschnitt (312) befindet, und eine Vielzahl von Säulen (430) beinhaltet, die in Richtung der Basis (411) hervorstehen und ein Ende (430a) beinhalten, das eine flache Form an einer Position angrenzend an die Basis (411) aufweist; und
wobei die Vielzahl von Säulen (430) Folgendes beinhaltet:
einen ersten Satz von Säulen (431), die ein erstes Muster (p1) in dem ersten Bereich (421) und dem zweiten Bereich (422) aufweisen; **dadurch gekennzeichnet, dass** die Vielzahl von Säulen (430) ferner Folgendes beinhaltet
einen zweiten Satz von Säulen (432), die ein zweites Muster (p2) aufweisen, das sich von dem ersten Muster (p1) in dem dritten Bereich (423) unterscheidet, wobei das zweite Muster (p2) mindestens eine Verstärkungsrippe (510) beinhaltet, mit der mindestens einige des zweiten Satzes von Säulen (432) verbunden sind.

2. Elektronische Vorrichtung (101) nach Anspruch 1,
wobei die mindestens eine Verstärkungsrippe (510) eine Vielzahl von Verstärkungsrippen beinhaltet, die jeweils eine Länge in einer ersten Richtung aufweisen, und
wobei das zweite Muster (p2) einen Satz von Verstärkungsrippen (511) beinhaltet, die in einer zweiten Richtung senkrecht zu der ersten Richtung angeordnet sind.

3. Elektronische Vorrichtung (101) nach Anspruch 1,
wobei das erste Muster (p1) eine Form aufweist, bei der jede des ersten Satzes von Säulen (431) in einem ersten Abstand (d1) voneinander beabstandet ist, und
wobei die mindestens eine Verstärkungsrippe zwei bis acht Säulen beinhaltet, die in dem ersten Abstand in einer ersten Richtung aus dem zweiten Satz von Säulen (432) voneinander beabstandet sind.

4. Elektronische Vorrichtung (101) nach einem der Ansprüche 1 bis 3,
wobei das erste Muster (p1) eine Form aufweist, bei der jede des ersten Satzes von Säulen (431) in einem ersten Abstand (d1) voneinander beabstandet ist, und
wobei das zweite Muster (p2) eine Form aufweist, bei der eine Säule (632a) aus dem zweiten Satz von Säulen (432) in einem zweiten Abstand (d2), der kleiner ist als der erste Abstand (d1), von einer anderen Säule (632b), die der einen Säule (632a) am nächsten ist, beabstandet ist.

5. Elektronische Vorrichtung (101) nach einem der Ansprüche 1 bis 4,
wobei das erste Muster (p1) eine Form aufweist, bei der jede des ersten Satzes von Säulen (431) in einem ersten Abstand (d1) voneinander beabstandet ist, und
wobei das zweite Muster (p2) eine Form aufweist, bei der eine Säule (632c) aus dem zweiten Satz von Säulen (432) in einem dritten Abstand (d3), der größer ist als der erste Abstand (d1), von einer anderen Säule (632d) beabstandet ist, die aus Säulen, die die eine Säule (632c) umgeben, am weitesten von der einen Säule (632c) entfernt ist.

6. Elektronische Vorrichtung (101) nach einem der Ansprüche 1 bis 5,
wobei das erste Muster (p1) eine Form aufweist, bei der jede des ersten Satzes von Säulen (431) in einem ersten Abstand (d1) voneinander beabstandet ist, und
wobei der zweite Satz von Säulen (432) Folgendes beinhaltet:
einen dritten Satz von Säulen (433), die in dem ersten Abstand (d1) in einer ersten Richtung in dem zweiten Muster (p2) voneinander beabstandet sind; und
einen vierten Satz von Säulen (434), die in einem dritten Abstand (d3) in der ersten Richtung, der größer ist als der erste Abstand (d1), voneinander beabstandet sind und in einer zweiten Richtung senkrecht zu der ersten Richtung in Bezug auf den dritten Satz von Säulen (433) in dem zweiten Muster (p2) angeordnet sind.

7. Elektronische Vorrichtung (101) nach einem der Ansprüche 1 bis 6,
wobei eine Steifigkeit des dritten Bereichs (423) größer ist als eine Steifigkeit des ersten Bereichs (421) und die Steifigkeit des zweiten Bereichs (422).

8. Elektronische Vorrichtung (101) nach einem der Ansprüche 1 bis 7,
wobei die zweite Platte (420) ferner ein drittes Muster (p3) beinhaltet, das mindestens eine Verstärkungsrippe (510) beinhaltet, mit der mindestens einige der Vielzahl von Säulen (430) verbunden sind, die entlang eines Umfangs der zweiten Platte (420) angeordnet sind.

9. Elektronische Vorrichtung (101) nach einem der Ansprüche 1 bis 8,
wobei der erste Abschnitt (311) eine erste Trägerstruktur (311a) beinhaltet, die die erste Platte (410) trägt,
wobei der zweite Abschnitt (312) eine zweite Trägerstruktur (312b) beinhaltet, die von einer Innenfläche der Setznut (310) hervorsteht und entlang eines Umfangs des Schlitzes (312a) angeordnet ist, und
wobei die Dampfkammer (400) ferner einen Flanschabschnitt (460) beinhaltet, der entlang eines Umfangs der Dampfkammer (400) angeordnet ist und die Dampfkammer (400) durch die zweite Trägerstruktur (312b) trägt.

10. Elektronische Vorrichtung (101) nach Anspruch 9,
wobei der Flanschabschnitt (460) Folgendes beinhaltet:
einen ersten Vorsprung (461), der sich von mindestens einem Abschnitt des zweiten Bereichs (422) und des dritten Bereichs (423) der zweiten Platte (420) erstreckt; und
einen zweiten Vorsprung (462), der sich von einem Umfang der Seitenwand (412) der ersten Platte (410) erstreckt und den ersten Vorsprung (461) trägt.

11. Elektronische Vorrichtung (101) nach Anspruch 9 oder 10, ferner umfassend:
ein erstes Klebeelement (711), das zwischen der Basis (411) und der ersten Trägerstruktur (311a) angeordnet ist; und
ein zweites Klebeelement (712), das zwischen dem Flanschabschnitt (460) und der zweiten Trägerstruktur (312b) angeordnet ist.

12. Elektronische Vorrichtung (101) nach einem der Ansprüche 1 bis 11,
wobei die Dampfkammer (400) ferner Folgendes beinhaltet:
einen Raum (S), der von der ersten Platte (410) und der zweiten Platte (420) bedeckt ist und eine Flüssigkeit beinhaltet; und
einen Docht (450) zum Bewegen des Fluids in einem flüssigen Zustand und zum Berühren der Basis (411) in dem Raum (S); und
wobei die erste Platte (410) konfiguriert ist, um den Raum (S) zusammen mit der zweiten Platte (420) abzudichten.

13. Elektronische Vorrichtung (101) nach einem der Ansprüche 1 bis 12,
wobei eine Breite (w1) der Basis (411), die auf dem ersten Abschnitt (311) angeordnet ist, größer ist als eine Breite (w2) der Basis (411), die auf dem zweiten Abschnitt (312) angeordnet ist.

14. Elektronische Vorrichtung (101) nach einem der Ansprüche 1 bis 13,
wobei die Dampfkammer (400) ferner mindestens eines von Edelstahl und Titan beinhaltet.

## Revendications

1. Dispositif électronique (101) comprenant :
une carte de circuit imprimé (250) ;
un processeur (120) sur la carte de circuit imprimé (250) ;
une chambre de vapeur (400) espacée de la carte de circuit imprimé (250) et disposée au moins partiellement sur le processeur (120) ; et
une plaque métallique (300), disposée sur la carte de circuit imprimé (250), comprenant une rainure d'assise (310) dans laquelle au moins une partie de la chambre de vapeur (400) est logée et comprenant une première partie (311) sur le processeur (120) pour transférer la chaleur émise par le processeur (120) à la chambre de vapeur (400) et une seconde partie (312) s'étendant à partir de la première partie (311) et ayant une fente (312a) formée dans celle-ci ; et,
dans lequel, la chambre de vapeur (400) comprend :
une première plaque (410) comprenant une base (411) supportée par la première partie (311) de la rainure d'assise (310) et ayant au moins une partie disposée sur la fente (312a), et une paroi latérale (412) s'étendant à partir d'une périphérie de la base (411) vers un extérieur de la rainure d'assise (310) ; et
une seconde plaque (420) en contact avec la paroi latérale (412) et comprenant une première région (421) disposée sur la première partie (311), une deuxième région (422) disposée sur la fente (312a) de la seconde partie (312), une troisième région (423) s'étendant de la première région (421) à la deuxième région (422) et située sur la limite (b) entre la première partie (311) et la seconde partie (312), et une pluralité de piliers (430) faisant saillie vers la base (411) et comprenant une extrémité (430a) ayant une forme plate à une position adjacente à la base (411) ; et,
dans lequel, la pluralité de piliers (430) comprend :
un premier ensemble de piliers (431) ayant un premier motif (p1) dans la première région (421) et la deuxième région (422) ;
**caractérisé en ce que** la pluralité de piliers (430) comprend en outre un deuxième ensemble de piliers (432) ayant un deuxième motif (p2) différent du premier motif (p1) dans la troisième région (423), le deuxième motif (p2) comprenant au moins une perle (510) à laquelle au moins certains du deuxième ensemble de piliers (432) sont connectés.

2. Dispositif électronique (101) de la revendication 1,
dans lequel l'au moins une perle (510) comprend une pluralité de perles ayant chacune une longueur dans une première direction, et
dans lequel le deuxième motif (p2) comprend un ensemble de perles (511) agencées dans une seconde direction perpendiculaire à la première direction.

3. Dispositif électronique (101) de la revendication 1,
dans lequel le premier motif (p1) a une forme dans laquelle chaque élément du premier ensemble de piliers (431) sont espacés les uns des autres d'une première distance (d1), et
dans lequel, l'au moins une perle comprend deux à huit piliers espacés les uns des autres de la première distance dans une première direction parmi le deuxième ensemble de piliers (432).

4. Dispositif électronique (101) de l'une quelconque des revendications 1 à 3,
dans lequel le premier motif (p1) a une forme dans laquelle chaque élément du premier ensemble de piliers (431) sont espacés les uns des autres d'une première distance (d1), et
dans lequel, le deuxième motif (p2) a une forme dans laquelle un pilier (632a) parmi le deuxième ensemble de piliers (432) est espacé d'une deuxième distance (d2) inférieure à la première distance (d1) d'un autre pilier (632b) le plus proche de ce pilier (632a).

5. Dispositif électronique (101) de l'une quelconque des revendications 1 à 4,
dans lequel le premier motif (p1) a une forme dans laquelle chaque élément du premier ensemble de piliers (431) sont espacés les uns des autres d'une première distance (d1), et
dans lequel le deuxième motif (p2) a une forme dans laquelle un pilier (632c) parmi le deuxième ensemble de piliers (432) est espacé d'une troisième distance (d3) supérieure à la première distance (d1) d'un autre pilier (632d) le plus éloigné de ce pilier (632c) parmi les piliers entourant ce pilier (632c).

6. Dispositif électronique (101) de l'une quelconque des revendications 1 à 5,
dans lequel le premier motif (p1) a une forme dans laquelle chaque élément du premier ensemble de piliers (431) sont espacés les uns des autres d'une première distance (d1), et
dans lequel le deuxième ensemble de piliers (432) comprend :
un troisième ensemble de piliers (433) espacés les uns des autres de la première distance (d1) dans une première direction dans le deuxième motif (p2) ; et
un quatrième ensemble de piliers (434) espacés les uns des autres d'une troisième distance (d3) dans la première direction supérieure à la première distance (d1) et disposés dans une seconde direction perpendiculaire à la première direction par rapport au troisième ensemble de piliers (433) dans le deuxième motif (p2).

7. Dispositif électronique (101) de l'une quelconque des revendications 1 à 6,
dans lequel une rigidité de la troisième région (423) est supérieure à une rigidité de la première région (421) et à la rigidité de la deuxième région (422).

8. Dispositif électronique (101) de l'une quelconque des revendications 1 à 7,
dans lequel la seconde plaque (420) comprend en outre un troisième motif (p3) comprenant au moins une perle (510) à laquelle au moins certains de la pluralité de piliers (430) disposés le long d'une périphérie de la seconde plaque (420) sont connectés.

9. Dispositif électronique (101) de l'une quelconque des revendications 1 à 8,
dans lequel la première partie (311) comprend une première structure de support (311a) supportant la première plaque (410),
dans lequel la seconde partie (312) comprend une seconde structure de support (312b) faisant saillie à partir d'une surface interne de la rainure d'assise (310) et disposée le long d'une périphérie de la fente (312a), et
dans lequel la chambre de vapeur (400) comprend en outre une partie de bride (460) disposée le long d'une périphérie de la chambre de vapeur (400) et supportant la chambre de vapeur (400) à travers la seconde structure de support (312b).

10. Dispositif électronique (101) de la revendication 9,
dans lequel la partie de bride (460) comprend :
une première saillie (461) s'étendant à partir d'au moins une partie de la deuxième région (422) et de la troisième région (423) de la seconde plaque (420) ; et
une seconde saillie (462) s'étendant à partir d'une périphérie de la paroi latérale (412) de la première plaque (410) et supportant la première saillie (461).

11. Dispositif électronique (101) de la revendication 9 ou 10, comprenant en outre :
un premier élément adhésif (711) disposé entre la base (411) et la première structure de support (311a) ; et
un second élément adhésif (712) disposé entre la partie de bride (460) et la seconde structure de support (312b).

12. Dispositif électronique (101) de l'une quelconque des revendications 1 à 11,
dans lequel la chambre de vapeur (400) comprend en outre :
un espace (S) couvert par la première plaque (410) et la seconde plaque (420) et comprenant un fluide ; et
une mèche (450) pour déplacer le fluide à l'état liquide et venir en contact avec la base (411) dans l'espace (S) ; et,
dans lequel la première plaque (410) est conçue pour sceller l'espace (S) à la seconde plaque (420).

13. Dispositif électronique (101) de l'une quelconque des revendications 1 à 12,
dans lequel une largeur (w1) de la base (411) disposée sur la première partie (311) est supérieure à une largeur (w2) de la base (411) disposée sur la seconde partie (312).

14. Dispositif électronique (101) de l'une quelconque des revendications 1 à 13,
dans lequel la chambre de vapeur (400) comprend en outre au moins un de l'acier inoxydable et du titane.
